# EUROPEAN PATENT APPLICATION

(11) **EP 4 822 993 A1**
(43) Date of publication of application: **14.10.2026**
(21) Application number: 26171319.2
(22) Date of filing: 08.04.2026
(51) Int. Cl.: H03K 17/95

(54) **PROXIMITY SENSOR DEVICE, SYSTEM, AND METHOD PRODUCING SAID DEVICE**

(30) Priority: 09.04.2025 EP 25472003
(71) Applicant: Melexis Bulgaria EOOD, 1138 Sofia (BG)
(72) Inventor: Hristov, Hristo, 1138 Sofia (BG); Kaliya Perumal Veerapandian, Savita, 8900 Ieper (BE); van der Wiel, Appo, 3980 Tessenderlo-Ham (BE); Ruythooren, Wouter, 3980 Tessenderlo-Ham (BE)
(74) Representative: Jacobs, Lambert

(57) **Abstract**

A proximity sensor device (101) comprising: a first coil arrangement comprising a first excitation coil (TX1) and a first receiver coil (RX1) implemented in at least one first RDL layer; a second coil arrangement comprising a second excitation coil (TX2) and a second receiver coil (RX2) implemented in at least one second RDL layer, spaced from the first RDL layers by at least 200 µm; a semiconductor device (10) arranged in a space between the first and second RDL layers, and comprising an excitation circuit (213; 313) for exciting the excitation coil, and a receiver circuit (214; 314) for receiving one or more signals; and an evaluation circuit (215; 315) for determining a position of an electrically conductive target (102), which is movable towards and away from the proximity sensor device. A proximity sensor system comprising said device and said movable target. A method of producing the proximity sensor device.

## Description

### Field of the invention

The present invention relates in general to the field of proximity sensors, and more in particular to inductive proximity sensor devices and systems, and method of producing such proximity sensors.

### Background of the invention

Proximity sensor devices and proximity sensor systems are known in the art. They are typically based on sensing a static magnetic field generated by a permanent magnet, or by sensing a dynamic magnetic field generated by a transmitter coil conducting an alternating current. A characteristic of the magnetic field is changed depending on the position of a movable object (e.g. a "metal target").

The present invention is directed to proximity sensors of the inductive type, sometimes also referred to as "inductive proximity switch", because the sensor device typically only has to differentiate between one of two possible positions of the movable target.

An example of an inductive proximity switch is described in US8203335.

There is always room for improvements or alternatives.

### Summary of the invention

It is an object of the present invention to provide a proximity sensor device, and a method of producing same.

It is also an object of the present invention to provide a proximity sensor system comprising such a device and a target which is movably arranged relative to said device, e.g. an electrically conductive target (e.g. a metal target, or a printed circuit board with a conductive layer or with conductive tracks), or a magnetic target (e.g. a ferromagnetic target, or a target comprising ferromagnetic particles).

It is an object of embodiments of the present invention to provide a proximity sensor device and system capable of reliably detecting the presence of an electrically conductive target or a magnetic target at a distance (air-gap) up to a predefined distance from the device. The predefined distance may be up to 0.5 mm from the device, or up to 1.0 mm, or up to 1.5 mm, or up to 2.0 mm, or up to 2.5 mm, or up to 3.0 mm, or up to 3.5 mm, or even up to 4.0 mm.

It is an object of embodiments of the present invention to provide a proximity sensor device and system that comprises a semiconductor substrate with an active surface, and that is capable of reliably detecting a distance (e.g. up to about 3.0 mm or up to 4.0 mm) between said sensor device and an electrically conductive target that is movable towards and away from the sensor device, e.g. in a direction substantially perpendicular to said active surface (also referred to as the Z-direction), or e.g. in a direction substantially parallel to said active surface.

It is an object of embodiments of the present invention to provide a proximity sensor device and system that is capable of reliably detecting the presence or absence or distance of an electrically conductive target having a size that is independent from the size of the proximity sensor device, e.g. a target having a cross-section (measured in a plane parallel to an active surface of the semiconductor device comprised in the device) that is larger than 2.0 mm x 2.0 mm, or larger than 3 x 3 mm, or larger than 4 x 4 mm.

It is an object of embodiments of the present invention to provide a proximity sensor system where the mounting requirements of the movable target are relaxed (especially, the requirements in the X and Y direction, parallel to the semiconductor substrate).

It is an object of embodiments of the present invention to provide such a proximity sensor device having a semiconductor substrate (e.g. a CMOS substrate) and coils, where the dimensions of the coils are larger than those of the semiconductor substrate.

It is an object of embodiments of the present invention to provide such a proximity sensor device consuming less than 50 mWatt, or less than 40 mWatt, or less than 30 mWatt, or less than 20 mWatt, e.g. typically consuming about 15 mWatt.

It is an object of embodiments of the present invention to provide such a proximity sensor device suitable for use in automotive, robotic or industrial applications.

These and other objects are accomplished by a proximity sensor device, a proximity sensor system, and a method of producing a proximity sensor device, according to embodiments of the present invention.

According to a first aspect, the present invention provides a proximity sensor device, comprising: a first coil arrangement comprising a first excitation coil and a first receiver coil implemented in at least one first redistribution layer; a second coil arrangement comprising a second excitation coil and a second receiver coil implemented in at least one second redistribution layer, spaced from the at least one first redistribution layer by at least 200 µm (or at least 250 µm, or at least 275 µm, or at least 300 µm, or at least 350 µm, or at least 400 µm, or at least 450 µm, or at least 500 µm, but preferably by at most 1500 µm, or at most 1250 µm, or at most 1000 µm); a semiconductor substrate arranged in a space between the at least one first redistribution layer and the at least one second redistribution layer such that the at least one first redistribution layer is arranged on a top side of the semiconductor substrate and the at least one second redistribution layer is arranged on a bottom side of the semiconductor substrate, the semiconductor substrate comprising an excitation circuit configured for exciting the first and second excitation coil, and comprising a receiver circuit configured for receiving one or more signals from the receiver coils (e.g. a combined signal of a series-connection of the two receiver coils); and comprising an evaluation circuit configured for determining a position (e.g. a distance value) or a value indicative of a position (e.g. a presence or an absence) of an electrically conductive target that is movable towards and away from the proximity sensor device, based on said one or more signals.

This proximity sensor device may be configured for estimating a distance between said target and the proximity sensor device, and/or for determining whether the movable target is relatively close to the proximity sensor device (e.g. closer than a predefined distance), and/or for determining that the movable target is relatively far from the proximity sensor device (e.g. further than a predefined distance).

The semiconductor substrate typically also comprises an "interconnection stack" comprising a plurality of conductive layers and dielectric layers and a plurality of "contact pads", as is well known in the art. Each of the redistribution layers also comprises a dielectric layer and a conductive layer, but these layers extend further than the semiconductor substrate in a direction parallel to the semiconductor substrate (e.g. X and Y in the drawings).

It is an advantage of providing two sets of coils, each including one transmitter coil and one receiver coil, on both sides of the semiconductor substrate (namely: one set above and one set below), because the mounting requirements of the target can be drastically relaxed. For example, the two coils enable to detect the position or the proximity of a target without imposing strict alignment requirements in the XY-direction, and/or allows detection of a target that overlaps the total surface of the sensor device.

Preferably, the proximity sensor device is a fan-out semiconductor package or a fan-out packaged device produced using Wafer-Level Packaging techniques, without an interposer.

Wafer-level fan-out in combination with through-vias, e.g. "through-glass vias" which are conductive paths provided through a glass-insert, or "through-mold vias" which are conductive paths provided through a molding compound, allows to create such a packaged device using existing processes, albeit that WLP-packaged device typically comprise an interposer, but the device of the present invention typically does not; and albeit that WLP packaged devices typically use a single stack of RDL layers (not two stacks as proposed herein), and typically use "through-vias" to connect to solder ball, not to connect ends of a second set of coils (as proposed herein).

Wafer-level fan-out furthermore allows the coils to be larger than the size of the semiconductor substrate, and more importantly, to design the coils with dimensions which are independent of the size of the semiconductor substrate.

In preferred embodiments, all coils are coreless, meaning that the packaged device does not contain magnetic material arranged inside the coils.

In an embodiment, the proximity sensor device is implemented as a WLP fan-out package comprising said semiconductor substrate; and said at least one first redistribution layer, and said at least one second redistribution layer; and wherein the package further comprises: a mould compound, and optionally further comprises one or more passive mechanical inserts; and wherein the package further comprises: a plurality of electrically conductive through-vias (e.g. TMV's) provided in the mould compound and/or electrically conductive through-vias provided in said one or more passive mechanical inserts, if present, for connecting the at least one second redistribution layer to the top side of the semiconductor substrate.

The proximity sensor device may further comprise one or more of the following: a plurality of terminals, a plurality of solder balls (22) or solder bumps provided on said terminals, one or more filler blocks provided in the mould compound, one or more discrete passive components selected from the group consisting of: a diode, a resistor, a capacitor.

In an embodiment, the proximity sensor device is implemented as a WLP fan-out package comprising or consisting of: a single semiconductor substrate, e.g. a single CMOS substrate; two or more first redistribution layers arranged on a top side of the semiconductor substrate, and one or more second redistribution layers arranged on a bottom side of the semiconductor substrate; a mould compound (e.g. an epoxy); a plurality of electrically conductive through-vias provided in the mould compound (e.g. in the form of through-mould-vias, TMV) and/or one or more (e.g. only one) mechanical insert (e.g. passive silicon substrate, or ceramic substrate or glass substrate) comprising a plurality of through-vias (e.g. in the form of through-glass-vias, TGV); a plurality of (e.g. at least three and at most eight, or from 3 to 6) solder balls or solder bumps; optionally one or more filler blocks (e.g. passive silicon substrate, ceramic substrate or glass substrate); optionally one or more discrete passive components selected from the group consisting of: a diode, a resistor, a capacitor.

The proximity sensor device of the present invention preferably does not comprise an interposer.

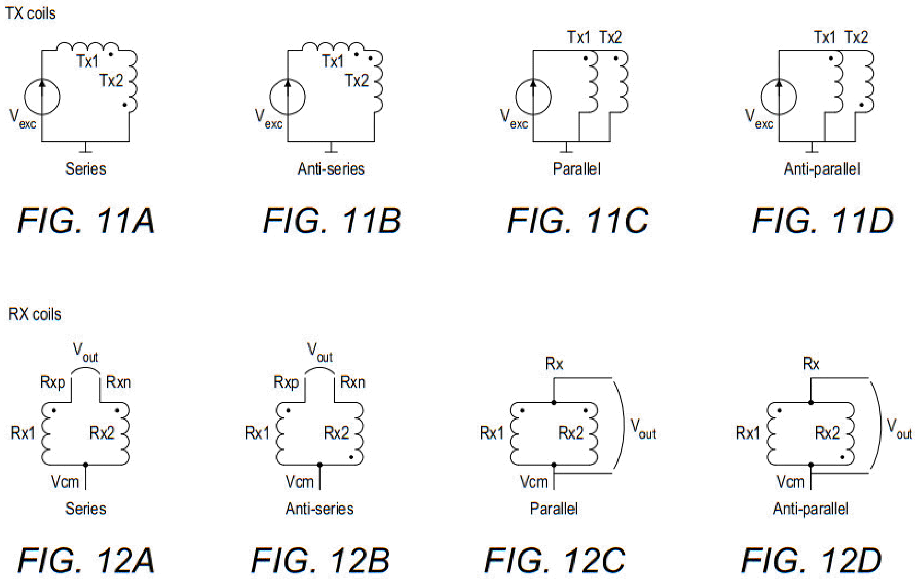

In an embodiment, the first transmitter coil and the second transmitter coil are connected in parallel, or in anti-parallel, or in series, or in anti-series, e.g. as illustrated in FIG. 11.

In an embodiment, the first receiver coil and the second receiver coil are connected in parallel, or in anti-parallel, or in series, or in anti-series, e.g. as illustrated in FIG. 12.

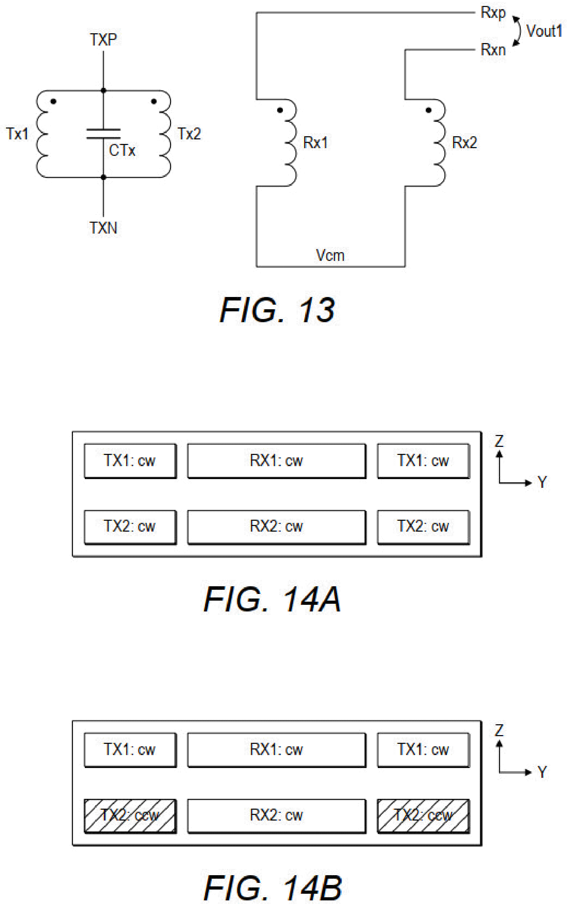

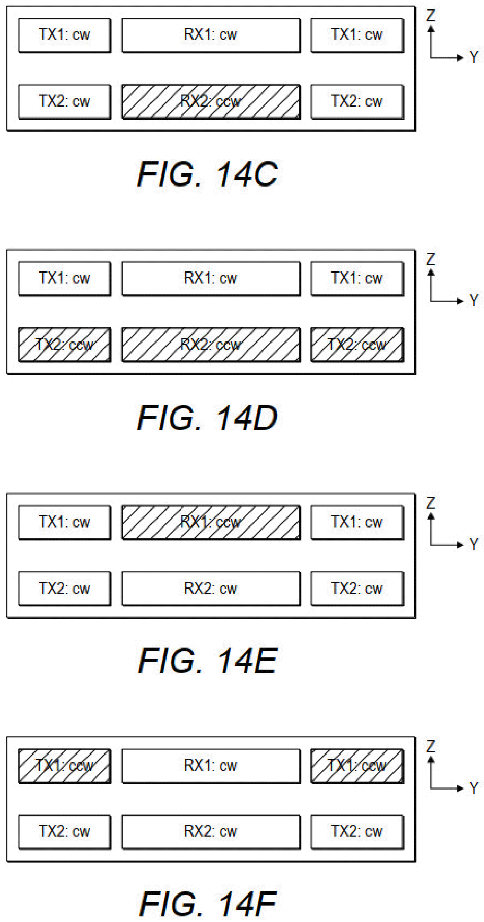

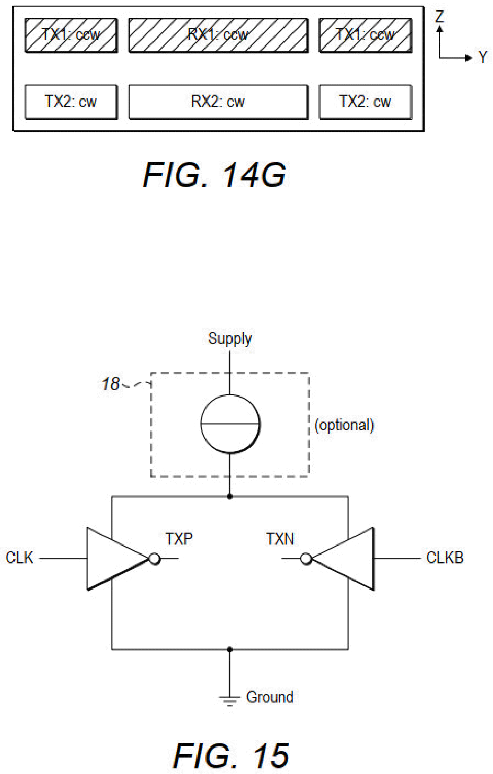

The windings of the first/second transmitter coil and of the first/second receiver coil may each be wound in a clockwise manner (cw), or in a counter-clockwise manner (ccw). A few possible combinations are illustrated in FIG. 14.

In an embodiment, the windings of TX1 and RX1 and TX2 and RX2 are wound in a clockwise manner (cw), e.g. as illustrated in FIG. 14A. In this embodiment, TX1 and TX2 are preferably electrically connected in parallel or in series, e.g. as illustrated in FIG. 11(a) or FIG. 11(c), and RX1 and RX2 are preferably electrically connected in series or in anti-parallel, e.g. as illustrated in FIG. 12(a) or FIG. 12(d).

In an embodiment, the windings of TX1 and RX1 and RX2 are wound in a clockwise manner (cw), and the windings of TX2 are wound in a counter-clockwise manner (ccw), e.g. as illustrated in FIG. 14B. In this embodiment, TX1 and TX2 are preferably connected in anti-parallel or in anti-series, while RX1 and RX2 are preferably connected in parallel or in anti-series.

In an embodiment, the windings of TX1 and RX1 and TX2 are wound in a clockwise manner (cw), and the windings of RX2 are wound in a counter-clockwise manner (ccw), e.g. as illustrated in FIG. 14C. In this embodiment, TX1 and TX2 are preferably connected in parallel or in series, while RX1 and RX2 are preferably connected in anti-series or in parallel.

In an embodiment, the windings of TX1 and RX1 are wound in a clockwise manner (cw), and the windings of TX2 and RX2 are wound in a counter-clockwise manner (ccw), e.g. as illustrated in FIG. 14D. In this embodiment, TX1 and TX2 are preferably connected in anti-parallel or in anti-series, while RX1 and RX2 are preferably connected in series or in anti-parallel.

In an embodiment, the windings of TX1 and TX2 and RX2 are wound in a clockwise manner (cw), and the windings of RX1 are wound in a counter-clockwise manner (ccw), e.g. as illustrated in FIG. 14E. In this embodiment, TX1 and TX2 are preferably connected in parallel or in series, while RX1 and RX2 are preferably connected in anti-series or in parallel.

In an embodiment, the windings of RX1 and TX2 and RX2 are wound in a clockwise manner (cw), and the windings of TX1 are wound in a counter-clockwise manner (ccw), e.g. as illustrated in FIG. 14F. In this embodiment, TX1 and TX2 are preferably connected in anti-parallel or in anti-series, while RX1 and RX2 are preferably connected in anti-series or in parallel.

In an embodiment, the windings of TX2 and RX2 are wound in a clockwise manner (cw), and the windings of TX1 and RX1 are wound in a counter-clockwise manner (ccw), e.g. as illustrated in FIG. 14G. In this embodiment, TX1 and TX2 are preferably connected in anti-parallel or in anti-series, while RX1 and RX2 are preferably connected in series or in anti-parallel.

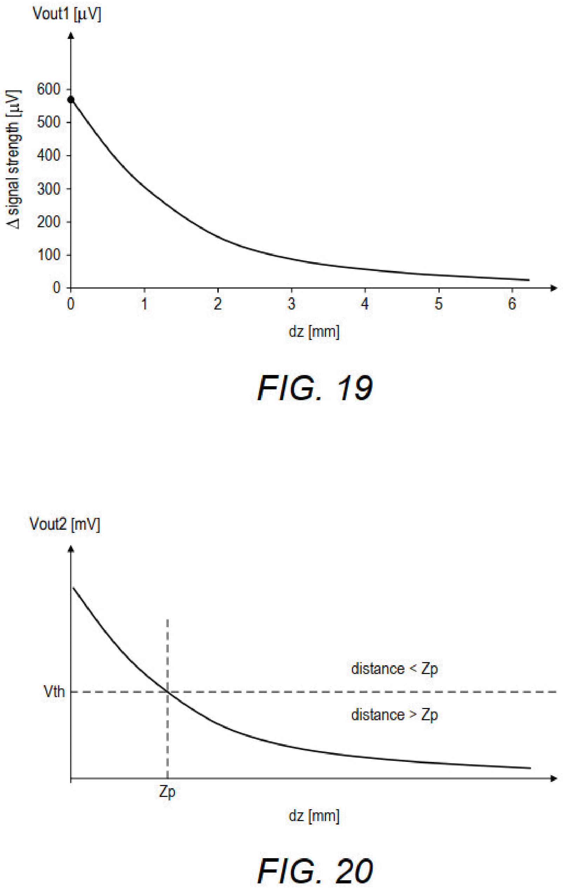

Ideally, in all of these configurations, the output voltage provided by the receiver circuit to the evaluation circuit is substantially equal to zero Volts in the absence of the movable target, but in practice a value smaller than 10 µV, or smaller than 20 µV, or smaller than 50 µV, or smaller than 100 µV will also work; but the output voltage is quite different from zero Volt (e.g. at least 200 µV ) in the presence of the target (e.g. if the target is at a distance smaller than 1.5 mm, or smaller than 1.0 mm), e.g. as illustrated in FIG. 19.

In an embodiment, the first transmitter coil (e.g. TX1) and the second transmitter coil (e.g. TX2) are configured (e.g. wound and/or interconnected and/or excited) in such a manner as to generate two constructive magnetic fields at a central location between (e.g. halfway between) the first and second transmitter coil, in the absence of the movable target.

In another embodiment, the first transmitter coil (e.g. TX1) and the second transmitter coil (e.g. TX2) are configured (e.g. wound and/or interconnected and/or excited) in such a manner as to generate two destructive magnetic fields at a central location between (e.g. halfway between) the first and second transmitter coil, in the absence of the target.

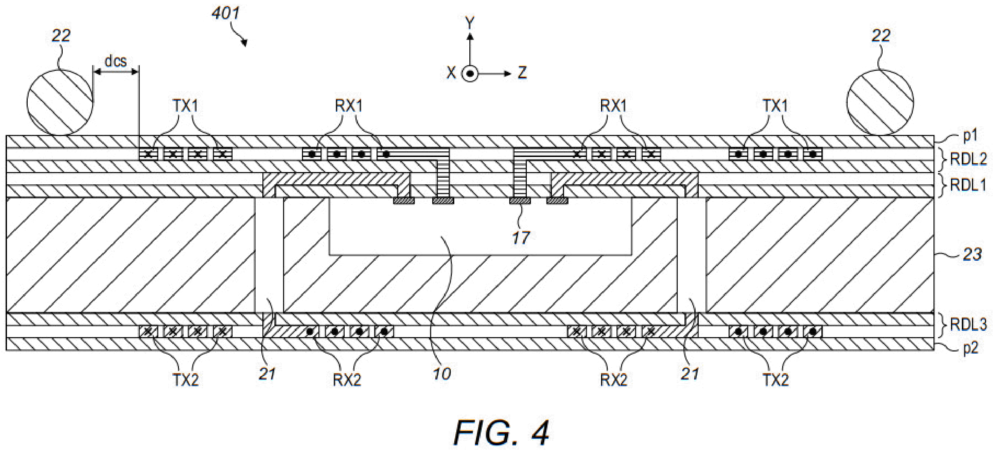

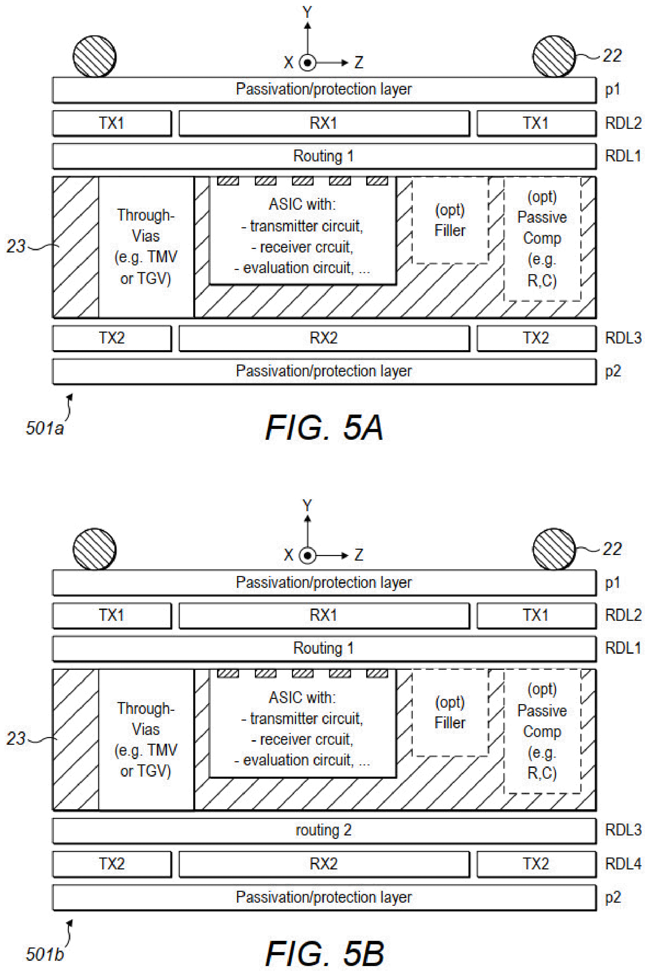

In an embodiment, each of the first transmitter coil (e.g. TX1) and the first receiver coil (e.g. RX1) have a spiral shape implemented in one or more redistribution layers (e.g. only in RDL2 as illustrated in the example of FIG. 4, FIG. 5A, FIG. 5B, FIG. 8, FIG. 9, FIG. 10B, FIG. 22F) located above the semiconductor substrate (on the side of the active layer of the semiconductor substrate); and each of the second transmitter coil (e.g. TX2) and the second receiver coil (e.g. RX2) have a spiral shape implemented in one or more redistribution layers (e.g. only in RDL3 as illustrated in the example of FIG. 4, FIG. 5A, FIG. 10B, FIG. 22G; or only in RDL4 as illustrated in the example of FIG. 5B, FIG. 8, FIG. 9) located under the semiconductor substrate (near the "backside" of the semiconductor substrate).

It is noted that the electrical connections to the ends of the spiral shapes may be located at least partially in another RDL layer.

In an embodiment, an orthogonal projection of at least one of the transmitter coils (e.g. TX1, TX2) and/or the receiver coils (e.g. RX1, RX2) onto a virtual plane containing the active surface of the semiconductor substrate, is located at least partially outside the semiconductor substrate.

Or stated in simple terms, in this embodiment, at least some of the coils have a "footprint" that is larger than the area defined by the semiconductor substrate.

As an example, the semiconductor substrate has a length and a width of about 1.50 mm x 1.00 mm, RX1 is located inside TX1, and an inner periphery of RX1 has a square shape with a size of at least 1.53 mm, and an outer periphery of TX1 has a square shape with a size of at least 3.00 mm, but of course this is only an example, and the present invention is not limited to this example.

In an embodiment, the proximity sensor device comprises at least two redistribution layers (e.g. RDL1 and RDL2 of the examples of FIG. 5B, or FIG. 8, or FIG. 9) situated above the semiconductor substrate, including at least one RDL-layer comprising the spiral windings of the TX1 coil and the RX1 coil, and at least one RDL-layer as a "routing layer" or "interconnection layer"; and the proximity sensor device comprises at least two redistribution layers (e.g. RDL3 and RDL4 of the examples of FIG. 5B, or FIG. 8, or FIG. 9) situated below the semiconductor substrate, including at least one RDL-layer comprising the spiral windings of the TX2 coil and the RX2 coil, and at least one RDL-layer as a "routing layer" or "interconnection layer". The routing layers (e.g. RDL1 and RDL3 in the examples of FIG. 5B, or FIG. 8, or FIG. 9) can be used to electrically connect the start and end of the TX1 and RX1 coils, and/or to electrically connect an upper side of the through-vias, and/or to electrically connect solder balls, and/or to electrically connect "contact pads" of the semiconductor substrate.

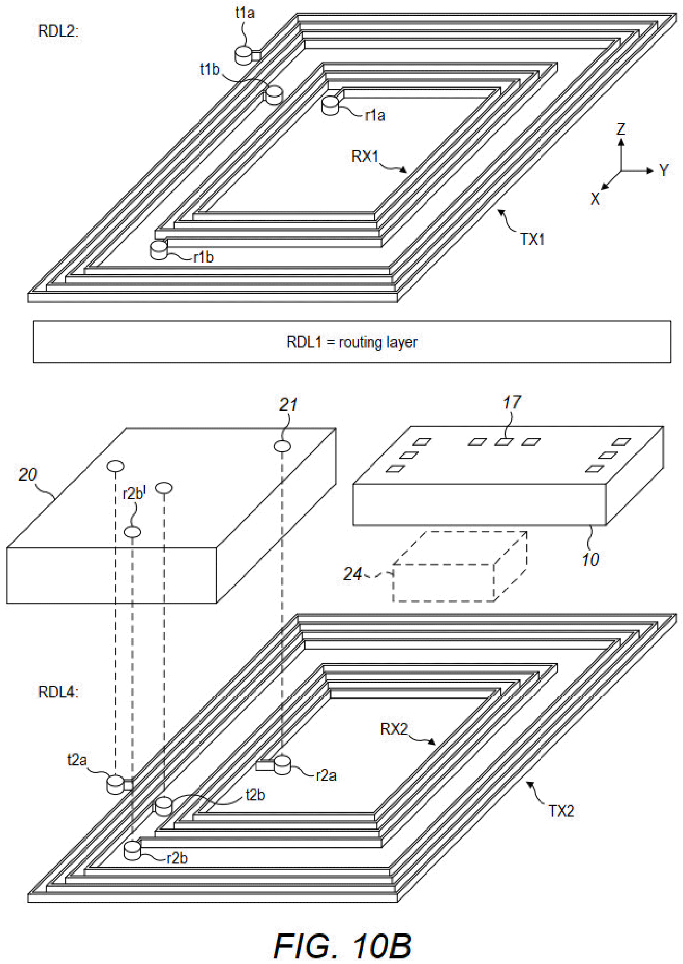

In an embodiment, the proximity sensor device comprises at least two redistribution layers (e.g. RDL1 and RDL2 of the examples of FIG. 5A, or FIG. 10B) situated above the semiconductor substrate, including at least one RDL-layer comprising the spiral windings of the TX1 coil and the RX1 coil, and at least one RDL-layer as a "routing layer" or "interconnection layer"; and the proximity sensor device comprises only one redistribution layer (e.g. RDL3 of the examples of FIG. 5A, or FIG. 10B) situated below the semiconductor substrate comprising the spiral windings of the TX2 coil and the RX2 coil.

In an embodiment, each of the first transmitter coil (e.g. TX1) and the first receiver coil (e.g. RX1) have a planar spiral shape implemented in a single redistribution layer (e.g. in RDL2) located above the semiconductor substrate; and each of the second transmitter coil (e.g. TX2) and the second receiver coil (e.g. RX2) have a planar spiral shape implemented in a single redistribution layer (e.g. in RDL3 in the example of FIG. 5A, or in RDL4 in the example of FIG. 5B) located under the semiconductor substrate.

It is noted that the proximity sensor device may have more than these two RDL layers in which the spiral windings are implemented, but will typically also have a third RDL layer (e.g. RDL1 in FIG. 5A and FIG. 5B) and optionally also a fourth RDL layer (e.g. RDL3 in FIG. 5B) for electrically connecting the ends of the coils to ends of other coils and/or to circuitry of the semiconductor device.

The third RDL layer, or "first routing layer" (e.g. RDL1 in FIG. 5A and FIG. 5B) may be situated between the interconnection stack of the semiconductor device, and the one or more first RDL layer(s) (e.g. RDL2 in FIG. 5A and FIG. 5B) that comprises the windings of the first coil arrangement.

The fourth RDL layer, or "second routing layer" (e.g. RDL3 in FIG. 5B) is not absolutely required, but if present, may preferably be situated between a bottom of the semiconductor substrate and the one or more second RDL layer(s) (e.g. RDL4 in FIG. 5B) that comprise the windings of the second coil arrangement (e.g. TX2 and RX2).

In an embodiment, the proximity sensor device further comprises: at least one passive substrate or passive insert with a plurality of through-vias, e.g. extending in the third direction Z, for electrically connecting [directly or indirectly] terminals or ends of the second coil arrangement (e.g. TX2, RX2) to the excitation circuit and/or to the receiver circuit; e.g. connected directly or indirectly to ends of the first coil arrangement (e.g. TX1, RX1) and/or connected directly or indirectly to contact pads of the semiconductor substrate, e.g. via conductive paths formed in one or more RDL layers acting as (a) routing layer(s).

It is an advantage of using one or more passive substrates rather than providing through-silicon vias through the semiconductor substrate, because it allows the size of the semiconductor substrate to be as small as possible, and because it allows a greater flexibility of the location of the through-vias.

The passive substrate may for example be a glass substrate, a ceramic substrate, a silicon substrate, or an organic substrate.

The passive substrate is situated in a space between the at least one first RDL layer and the at least one second RDL layer, e.g. between the two routing layers (RDL1 and RDL3) of FIG. 5B.

Preferably the total projected area (or footprint) of the at least one passive substrate (that contains the through-vias) onto a virtual plane containing the active surface of the semiconductor substrate, is smaller than the projected area of the semiconductor device, but the height of the passive substrate (in the Z-direction) is typically larger than the height of the semiconductor substrate.

In an embodiment, the first transmitter coil has a first spiral shape, and the first receiver coil has a second spiral shape located inside the first spiral shape, and wherein the second transmitter coil has a third spiral shape, and the second receiver coil has a fourth spiral shape located inside the third spiral shape.

In an embodiment, the first transmitter coil has a first spiral shape, and the first receiver coil has a second spiral shape located outside the first spiral shape, and the second transmitter coil has a third spiral shape, and the second receiver coil has a fourth spiral shape located outside the third spiral shape.

It is an advantage that the RX coils are situated inside the TX coils, or vice versa, because by doing so, more efficient use is made of the "available space" (e.g. as compared to implementation where TX and RX are implemented next to each other). Or stated in other words, by doing so, a more compact proximity sensor device can be obtained.

It is preferred that the RX coils are situated inside the TX coils, rather than the other way around, because the magnetic field sensed by the receiver coils may be weaker if the TX coils are located inside the RX coils.

In an embodiment, the first transmitter coil and the first receiver coil are concentric, and the second transmitter coil and the second receiver coil are concentric.

In an embodiment, a largest distance between any two of four orthogonal projections of a geometric centre of the first transmitter coil, a geometric centre of the second transmitter coil, a geometric centre of the first receiver coil, a geometric centre of the second receiver coil (onto an imaginary plane containing the active surface of the semiconductor device, is smaller than 1.0 mm, or smaller than 0.75 mm, or smaller than 0.50 mm, or smaller than 0.25 mm.

Or stated in simple terms: the spiral windings of TX1 and the spiral windings of RX1 have substantially a same (first) geometric centre within a tolerance margin of 1.0 mm or smaller, and the spiral windings of TX2 and the spiral windings of RX2 have substantially a same (second) geometric centre within a tolerance margin of 1.0 mm or smaller, and preferably an orthogonal projection of this first geometric centre and this second geometric centre onto the active surface substantially coincide, or are situated at a distance smaller than 1.0 mm from each other.

In an embodiment, the excitation circuit is configured for exciting the first transmitter coil and the second transmitter coil (TX2) synchronously.

Preferably TX1 and TX2 are excited simultaneously using a single excitation signal.

The transmitter coils may be excited using an excitation signal having frequencies in the range from 20 MHz to 30 MHz, e.g. of about 26 MHz.

The excitation circuit may comprise a modulator, e.g. a square wave modulator.

The receiver circuit may comprise a synchronous demodulator, e.g. using a BPSK (binary phase shift keying) waveform.

The excitation circuit may be configured to provide a current having an amplitude in the range from 1.0 to 3.0 mA into the transmitter coils, or in the range from 1.5 to 2.5 mA, or in the range from 1.75 to 2.25 mA.

In an embodiment, the transmitter coils (e.g. TX1, TX2) and the receiver coils (e.g. RX1, RX2) are configured such that a first voltage over the ends (e.g. r1a, r1b) of the first receiver coil (e.g. RX1) and a second voltage over the ends (e.g. r2a, r2b) of the second receiver coil (e.g. RX2) have a same amplitude within a predefined tolerance margin (e.g. less than ±2.0%, or less than ±1.0%, or less than ±0.5%, or less than ±0.4%, or less than ±0.3%, or less than ±0.2%) in the absence of the conductive target.

Depending on the winding directions, and depending on the connections or interconnections of the transmitter coils and receiver coils, the polarities of the first and second voltage may be the same or may be opposite.

In case the polarities of the first voltage and the second voltage are the same, a difference of the first and second voltage (v1, v2) will be smaller than a first predefined threshold value (e.g. smaller than 10 µV) in the absence of the conductive target or if the target is at a distance larger than 5.0 mm, but will be quite different from zero in the presence of the conductive target, e.g. larger than a second predefined threshold value (e.g. at least 400 µV if the conductive target is at a distance smaller than 0.5 mm).

In case the polarities of the first voltage and the second voltage are opposite, the same is true for a sum of the first and second voltage (v1, v2).

In a preferred embodiment, TX1 has a first number N1 of turns, and TX2 has (N1 ±1) number of turns, where N1 is a value in the range from 10 to 50, or from 15 to 40, or from 20 to 30, e.g. 25 turns, and RX1 has a second number N2 of turns, and RX2 has has (N2 ±1) number of turns, where N2 is a value in the range from 11 to 51, or from 16 to 41, or from 21 to 31, e.g. 26 turns, and TX1 and TX2 have substantially the same dimensions ±5% (e.g. same inner and outer diameter ±5%, and/or same length ±5% and/or same width ±5%), and RX1 and RX2 have same dimensions ±5%, and the windings of TX1 and TX2 have substantially the same cross-section (e.g. same height ±5% and same width ±5%), and the windings of RX1 and RX2 have substantially the same cross-section (e.g. same height ±5% and width ±5%).

Preferably the second coil arrangement is aligned with the first coil arrangement in a direction perpendicular to a plane containing the active surface of the semiconductor substrate. In practice this could mean for example that an orthogonal projection of most of the windings of TX1 and TX2 may coincide, e.g. all windings except the innermost and outermost winding or turn; and the same is preferably also true for RX1 and RX2.

In a preferred embodiment, the windings of the coils have a height (or thickness) of 4.0 µm ± 1.0 µm, and have a width of 5.0 µm ± 1.0 µm, and two adjacent windings may be spaced by a distance of 7.5 µm ± 1.0 µm. It was found that coils with coils with such windings provide a sufficiently large number of turns to create a magnetic field that can be used to reliably detect the presence of said target at a predefined distance of say e.g. 3.0 mm or smaller. This will not provide an oscillator with an optimal Q-factor, but with a larger inductance, and a stronger magnetic field, which is beneficial for reliable detection.

In an embodiment, the windings of the first and second receiver coil have substantially the same layout, except for the connections at their respective ends. More specifically, in an embodiment, orthogonal projections of the windings of RX1 and RX2 onto a plane comprising the active surface of the semiconductor substrate overlap each other over at least 95% of their length, or at least 96%, or at least 97%, or at least 98%. This is especially desirable for the receiver coils, especially if the processing of the received signal(s) is derived from or based on a sum or a difference of the receiver signals.

In an embodiment, the windings of the first and second transmitter coil have substantially the same layout, except for the connections at their respective ends. More specifically, in an embodiment, orthogonal projections of the windings of TX1 and TX2 onto the plane comprising the active surface of the semiconductor substrate overlap each other over at least 90% of their length. This is not critical, however, for the invention to work, even if the processing of the received signal(s) is based on a sum or a difference of the receiver signals.

In an embodiment, the evaluation circuit is configured for determining a position of the movable target relative to the proximity sensor device (e.g. a distance from the proximity sensor device), based on a sum of the induced voltages over the receiver coils, or based on a difference of the induced voltages over the receiver coils.

Or more specifically, based on an amplitude of the sum signal, or based on an amplitude of the difference signal. In practice, the sum or difference signal may be generated by connecting the receiver coils in series, or in parallel, or in anti-series, or in anti-parallel; and in practice, the amplitude of the combined signal may not be measured directly, but the combined signal (e.g. obtained from the series connection or the parallel connection) may be amplified and demodulated to a DC-signal, which DC-signal may then be compared to a predefined threshold voltage.

In an embodiment, the proximity sensor device further comprises a switch having two ends electrically connected to two terminals (e.g. two solder balls or solder bumps) of the proximity sensor device; and wherein the evaluation circuit is further configured for determining a position of the target, and for selectively opening or closing the switch depending on the position of the movable target.

The switch may be a "Normally Open" switch, or a "Normally Closed" switch.

The switch may be implemented in the semiconductor substrate.

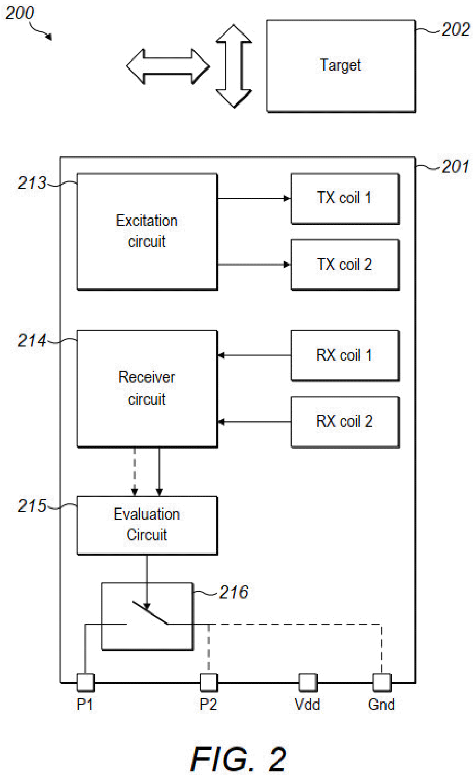

In the example of FIG. 2 the two terminals are two terminals dedicated to the switch function, which terminals may be electrically interconnected or disconnected by the switch, but the present invention is not limited thereto, and it is also possible, for example, to provide one dedicated terminal connected to one end of the chip (e.g. P1 of FIG. 2), and to connect the other end of the switch with a reference voltage, e.g. to the supply voltage Vdd, or to the ground voltage Gnd. In this case the terminal P2 (e.g. pin or solder ball) may be omitted.

In an embodiment, the evaluation circuit is further configured for determining a position of the target, and for providing a signal (e.g. a PWM signal, or an analog or digital signal, e.g. an analog current signal, or an analog voltage signal as a function of the distance, e.g. proportional to the distance) to one of the terminals (e.g. solder balls or solder bumps) of the proximity sensor device depending on the position of the movable target.

In an embodiment, the proximity sensor device further comprises a plurality of (e.g. from three to eight, or from three to six, e.g. exactly four) terminals or solder balls or solder bumps, electrically connected to contact pads or contact areas of the semiconductor device.

The terminals or solder balls are preferably located on the side of the package facing the top side of the semiconductor package, i.e. the side closest to the interconnection stack (i.e. near TX1 and RX1), because by doing so, no through-vias are required for the solder balls. Such a package is simpler to manufacture and/or requires less components (e.g. less glass inserts for creating the through-vias).

In an alternative embodiment, the plurality of terminals or solder balls are located on the side of the package facing the bottom side of the semiconductor substrate.

In an embodiment, the proximity sensor device has a plurality of terminals without solder material, intended for being mounted on a printed circuit board having solder material. Some or all of these terminals are electrically connected to contact pads of the semiconductor substrate. The terminals are accessible via openings made in the first or second protection layer p1, p2.

An orthogonal projection of these terminals or solder balls is preferably located outside an orthogonal projection of the coils, e.g. at a distance "dcs" of at least 100 µm from an outer periphery of the coils, or at least 150 µm, or at least 200 µm, or at least 250 µm. Closely located solder balls may cause imbalance between the first and second coil arrangement, resulting in a non-zero output voltage even in the absence of the target. In preferred embodiments, the sensor device has provisions to reduce such imbalance, e.g. using a programmable offset value stored in a non-volatile memory.

According to a second aspect, the present invention also provides a proximity sensor system comprising: a proximity sensor device according to the first aspect; and an electrically conductive target being movable towards and away from the proximity sensor device, e.g. from a first predefined position to a second predefined position, e.g. along a predefined trajectory.

In preferred embodiments, an orthogonal projection of the movable target (in a direction perpendicular to the active surface of the semiconductor substrate) fully overlaps the area defined by the coils, i.e. is larger than the outer periphery of the outer coil (e.g. first transmitter coil TX1 and/or second transmitter coil TX2).

According to a third aspect, the present invention also provides a method of producing a proximity sensor device according to the first aspect, the method comprising the steps of: a) providing a carrier wafer; b) applying a removable or releasable tape 31 (e.g. a thermal release tape or a laser release tape) on the carrier wafer; c) placing one or more components on the removable or releasable tape, the one or more components comprising at least a semiconductor substrate (e.g. cmos substrate) and optionally one or more passive inserts (e.g. passive silicon substrate, or ceramic substrate or glass substrate) comprising a plurality of through-vias; d) overmolding the wafer with a molding compound thereby forming a reconstituted wafer; e) back-grinding the reconstituted wafer; x) optionally making a plurality of openings in the moulding compound reaching to the removable or releasable tape, and filling them at least partially (e.g. only the sidewalls) with a conductive material; f) releasing the carrier wafer and the removable or releasable tape from the reconstituted wafer; g) forming two or more first redistribution layers (e.g. RLD1 and RDL2 in the examples of FIG. 5A and FIG. 5B) on a first side of the reconstituted wafer, in electrical connection with contact areas of the semiconductor substrate and/or in electrical connection with top sides of said through-vias, and wherein these first RDL layers comprise a first transmitter coil and a first receiver coil; h) forming one or more second redistribution layers (e.g. RLD3 and RDL4 in the example of FIG. 5B; or only RDL3 in the example of FIG. 5A) on a second side of the reconstituted wafer, opposite the first side, in electrical connection with bottom sides of said through vias, this one or more second RDL layer(s) comprising a second transmitter coil and a second receiver coil; i) optionally adding a plurality of solder balls or solder bumps on top of the at least first or at least second redistribution layer(s); j) singulating the reconstituted wafer.

The method may comprise a further step of providing a first passivation layer (e.g. p1) on top of the at least first RDL layer (e.g. on top of RDL2 in FIG. 5A, FIG. 5B, FIG. 8, FIG. 9, FIG. 10B), and optionally making an opening in this first passivation layer for exposing terminals and/or for connecting said solder balls or solder bumps, in case the terminals and/or solder balls are situated above the first passivation layer (e.g. p1).

The method may comprise a further step of providing a second passivation layer (e.g. p2) on top of the at least second RDL layer (e.g. on top of RDL3 in FIG. 5A and FIG. 10B; or on top of RDL4 in FIG. 5B, FIG. 8, FIG. 9), and optionally making an opening in this second passivation layer exposing terminals and/or for connecting said solder balls or solder bumps, in case the terminals and/or solder balls are situated above the second passivation layer (e.g. p2).

In an embodiment, step c) further comprises: placing one or more filler blocks (e.g. passive silicon substrate, ceramic substrate or glass substrate) on the thermal release tape.

In an embodiment, step c) further comprises: placing one or more discrete passive components selected from the group consisting of a diode, a resistor, a capacitor on the removable or releasable tape.

In an embodiment, step c) comprises: placing one or more components on the removable or releasable tape, the one or more components comprising at least a semiconductor substrate (e.g. cmos substrate) and one or more passive inserts (e.g. passive silicon substrate, or ceramic substrate or glass substrate) comprising a plurality of through-vias; and step e) comprises: back-grinding the reconstituted wafer, thereby exposing a bottom side of said through-vias.

It is noted that step f) can be omitted in this case.

In an embodiment, step c) comprises: placing one or more components on the removable or releasable tape, the one or more components comprising at least a semiconductor substrate (e.g. cmos substrate); and step e) comprises: back-grinding the reconstituted wafer; and step x) comprises: making a plurality of openings in the moulding compound extending to the removable or releasable tape, and filling them at least partially (e.g. by metalizing the sidewalls of the openings) with a conductive material.

According to another aspect, the present invention is also directed to a seat belt fastener, or to a seat-track-positioner, or to an EV charge port open/close detection, or an electronic steering column lock comprising a proximity sensor device according to the first aspect, and/or a proximity sensor system according to the second aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1A and FIG. 1B** show an illustrative example of a proximity sensor system according to embodiments of the present invention, comprising a proximity sensor device according to an embodiment of the present invention, optionally soldered on a printed circuit board, and further comprising an electrically conductive target movable towards and away from the proximity sensor device.
**FIG. 2** shows a high-level block-diagram of an illustrative example of a proximity sensor device according to an embodiment of the present invention, comprising two transmitter coils and two receiver coils, and a switch which is opened or closed depending on the detected position of a movable target.
**FIG. 3** shows another high-level block-diagram of an illustrative example of a proximity sensor device according to an embodiment of the present invention, comprising two transmitter coils and two receiver coils, and an interface circuit for outputting a value or signal indicative of the detected position of the conductive target.
**FIG. 4** shows a cross-sectional view of an illustrative example of a proximity sensor device according to an embodiment of the present invention.
**FIG. 5A** shows an abstract representation of FIG. 4.
**FIG. 5B** shows a variant of FIG. 5A for a sensor device having four RDL layers, two above, and two below the semiconductor substrate.
FIG. 5A and FIG. 5B may be jointly referred to as **FIG. 5****.**

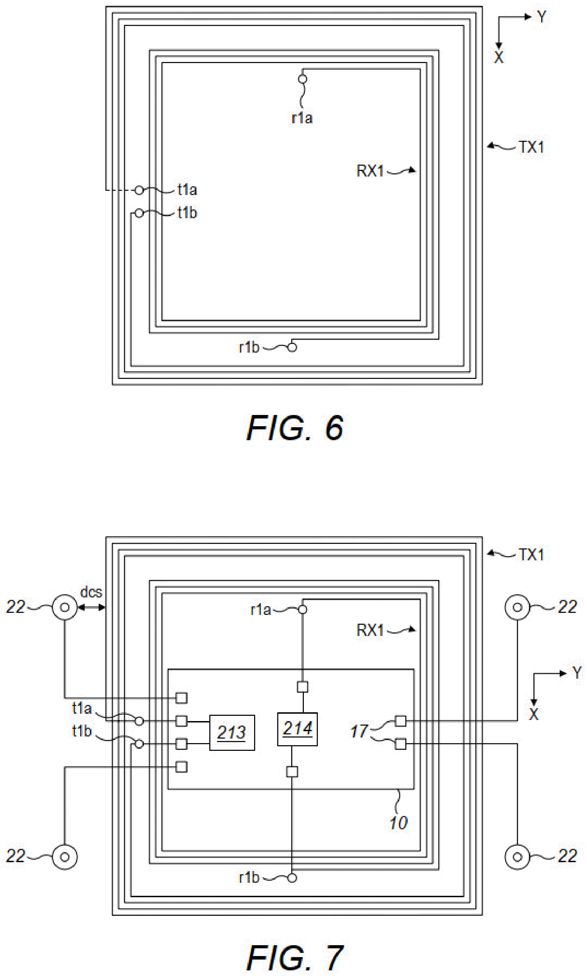

**FIG. 6** shows an illustrative example of a possible layout (or top view) of a transmitter coil and a receiver coil as may be used in embodiments of the present invention.
**FIG. 7** shows an illustrative example of a possible arrangement of a semiconductor substrate and a number of solder balls, relative to the coil arrangement such as the one of FIG. 6, as may be used in embodiments of the present invention.

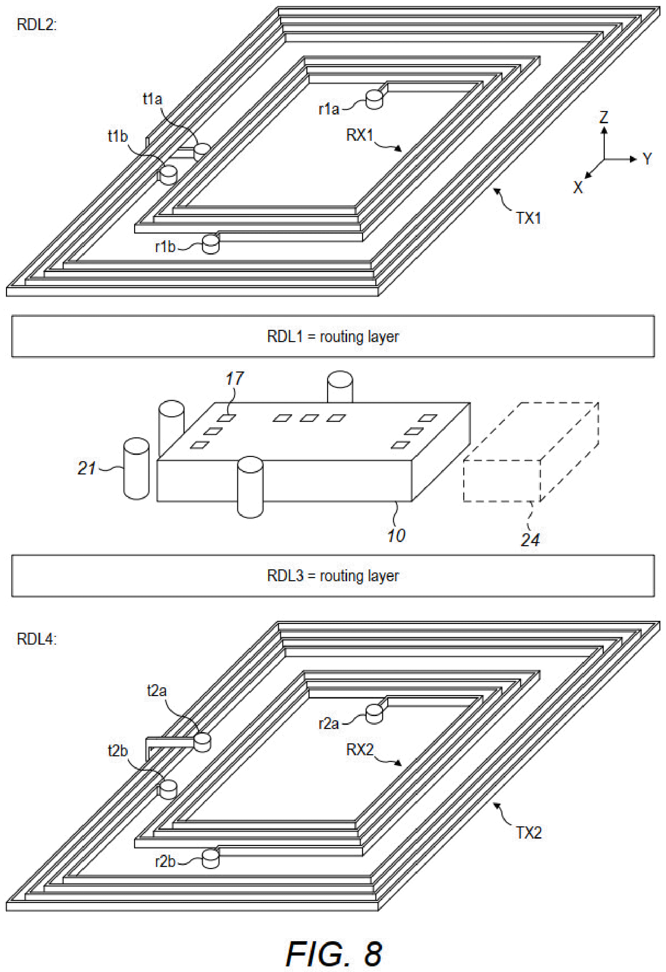

**FIG. 8** shows an illustrative example of a partial exploded view of a proximity sensor device according to an embodiment of the present invention, having four RDL layers and through-vias situated at various locations.

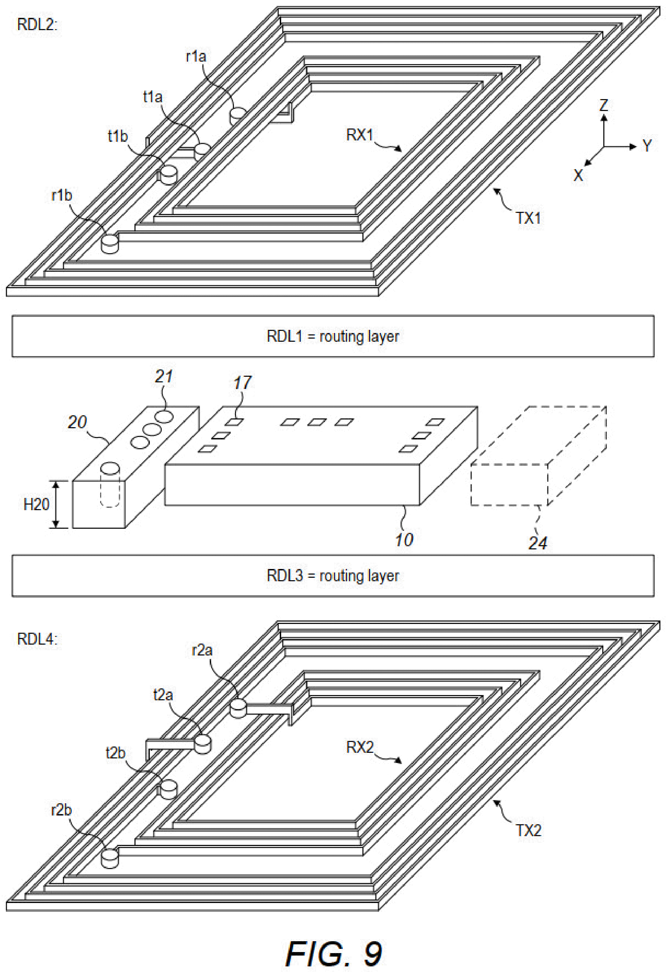

**FIG. 9** shows an illustrative example of a partial exploded view of a proximity sensor device according to an embodiment of the present invention, having four RDL layers and a passive insert with through-vias.

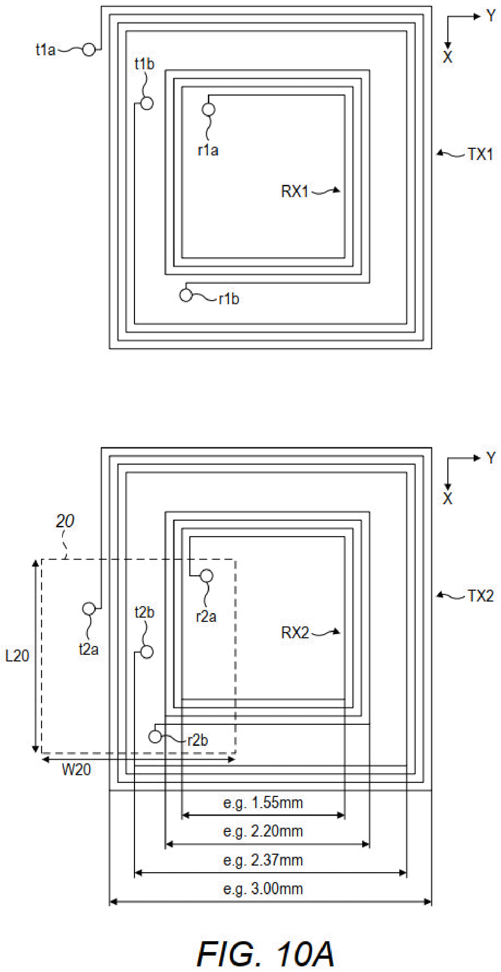

**FIG. 10A** shows a possible layout (or top view) of a first set of coils and a second set of coils, having substantially the same shape but having ends located at different locations, as may be used in embodiments of the present invention.
**FIG. 10B** shows an illustrative example of a partial exploded view of a proximity sensor device according to an embodiment of the present invention, having only three RDL layers comprising and connecting the coils of FIG. 10A.
FIG. 10A and FIG. 10B may be jointly referred to as **FIG. 10****.**
**FIG. 11** show examples of how the two transmitter coils may be interconnected.
**FIG. 12** show examples of how the two receiver coils may be interconnected.
**FIG. 13** shows an example in which the two transmitter coils are connected in parallel, and the two receiver coils are connected in series.
**FIG. 14A** to **FIG. 14G** are schematic representations showing possible combinations of coils being wound in a clockwise or counter-clockwise direction, as may be used in embodiments of the present invention. FIG. 14A to FIG. 14G may be jointly referred to as **FIG. 14****.**
**FIG. 15A** shows a block-diagram of an illustrative example of a transmitter circuit that may be used in embodiments of the present invention.

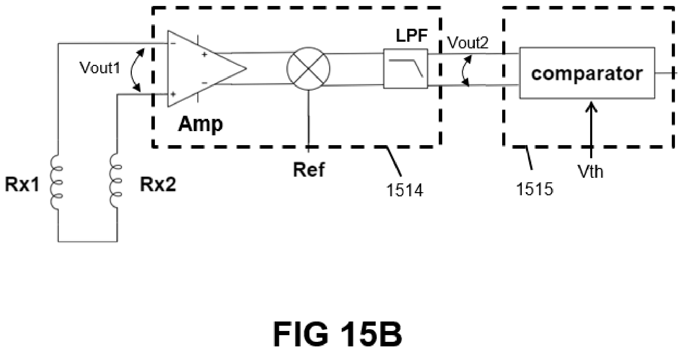

**FIG. 15B** shows a block-diagram of an illustrative example of a receiver circuit, followed by an illustrative example of an evaluation circuit, that may be used in embodiments of the present invention.
FIG. 15A and FIG. 15B may be jointly referred to as **FIG. 15****.**

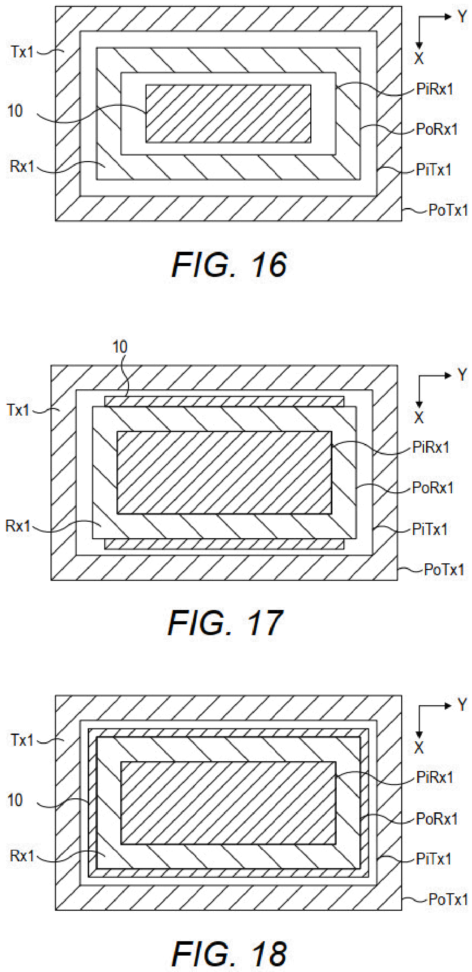

**FIG. 16 to FIG. 18** show a few illustrative examples illustrating that the dimensions of the semiconductor substrate and the dimensions of the coils are largely unrelated, in embodiments of the present invention.

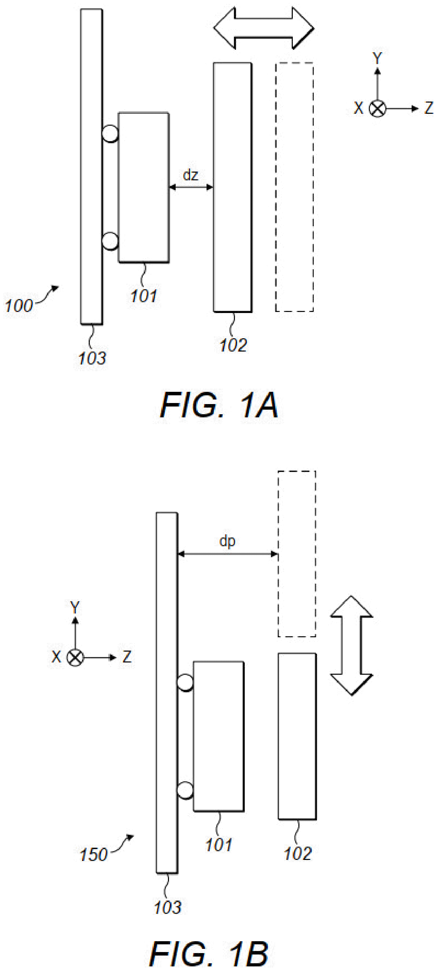

**FIG. 19** shows a graph showing an illustrative example of signal strength (derived from the signals obtained from the receiver coils) as a function of the distance dz between the movable target and the proximity sensor device, measured as illustrated in FIG. 1A.
**FIG. 20** shows an example wherein the received signal is compared to a threshold value, in order to determine whether the target is closer than, or further than a predefined distance from the proximity sensor device.

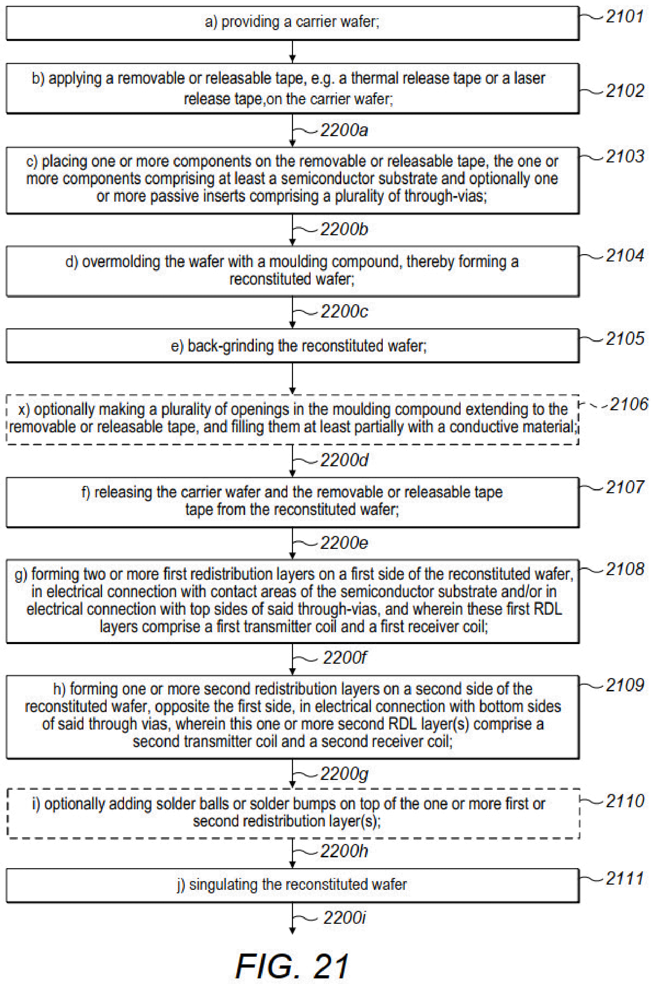

**FIG. 21** shows a flowchart of a method of producing a proximity sensor device, as another embodiment of the present invention.

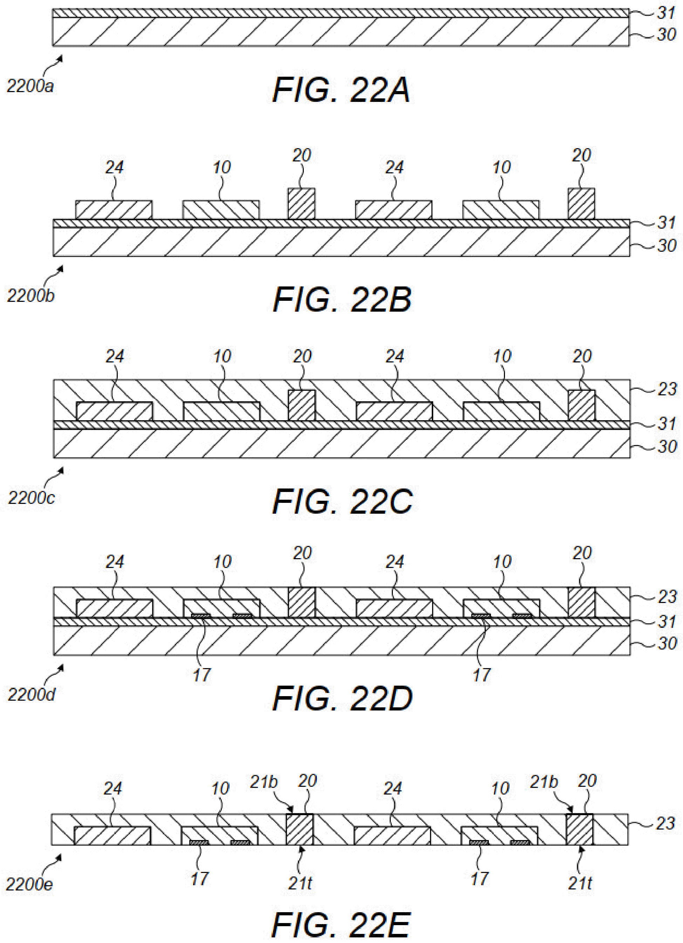

**FIG. 22A** to **FIG. 22I** show examples of devices obtained after performing various steps of the method of FIG. 21.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, the terms "spiral shape" means a continuous curve along a path followed by an imaginary point that moves around a central point in a clockwise or counter-clockwise manner multiple times, with a gradually increasing average diameter for each turn. The shape of a single turn may be substantially circular or substantially square or substantially rectangular or substantially hexagonal, etc. The ends of the spiral shape, and the electrical connections to these ends, are not considered part of the "spiral shape" itself. In preferred embodiments of the present invention, the windings or turns of each individual coil are implemented in a single RDL layer, but the electrical connection to the ends of the coils may be located partially outside this RDL layer.

With "inner periphery of a 2D spiral" is meant the periphery of the largest possible polygon (e.g. concave polygon) that fits inside the spiral shape.

With "outer periphery of a 2D spiral" is meant the periphery of the smallest possible polygon (e.g. concave polygon) that fits around the spiral shape.

The term "active surface" of a semiconductor substrate refers to the surface of the semiconductor substrate where active components (such as transistors) and/or passive components are formed (such as diodes, resistors, capacitors). The "interconnection stack" is formed on top of the active surface, and is in electrical contact thereto. The other side of the semiconductor substrate is referred to herein as the "backside" or "the back".

In this document, the terms "transmit circuit" and "transmitter circuit" and "excitation circuit" mean the same.

In this document, the terms "transmit coil" and "transmitter coil" and "excitation coil" and "TX coil" mean the same.

In this document, the terms "receiver circuit" and "reception circuit" mean the same.

In this document, the terms "receiver coil" and "reception coil" and "RX coil" mean the same.

In this document, the terms "periphery" or "circumference" mean the same.

In this document, the statement "the receiver coil is located inside the transmitter coil", means that an orthogonal projection of the receiver coil is located inside an orthogonal projection of the transmitter coil.

In this document, the terms "solder balls" and "solder bumps" mean the same.

In this document, the abbreviation "RDL layer" means redistribution layer. An RDL layer typically comprises a dielectric layer and a patterned conductive layer. The dielectric layer may comprise one or more conductive vias. The RDL layers extend further than the top surface of the semiconductor substrate, in the X and Y direction.

In this document, the abbreviation PCB means "printed circuit board", PWM means "pulse width modulation", BPSK means "binary phase shift keying", RDL means "redistribution layer", ASIC means "application specific integrated circuit".

In this document, the term "ASIC" can also be used to refer to the "semiconductor substrate" that comprises the transmitter circuit, receiver circuit and evaluation circuit.

In this document, the start and end of a coil may be jointly referred to as "the ends" or "the terminals" of the coil.

The present invention is related to inductive proximity sensor devices, and to proximity sensor systems comprising such a sensor device and further comprising an electrically conductive target which is movable relative to said sensor device, and to methods of producing such a sensor device.
Referring now to the Figures.

**FIG. 1A** shows an illustrative example of a proximity sensor system 100, comprising an inductive proximity sensor device 101, also referred to herein as "proximity sensor device" or as "sensor device". The sensor device 101 may be soldered on a printed circuit board 103. The system 100 further comprises an electrically conductive target 102, e.g. a metal plate, or an object comprising a metallic surface or area. The target 102 is movable towards and away from the proximity sensor device 101, e.g. in a direction perpendicular to the PCB 103, and the sensor device 101 may be capable of determining a distance dz between the sensor device 101 and the target 102. In the example shown in FIG. 1A, the target is movable in Z-direction, i.e. in direction perpendicular to the PCB, but the invention is not limited thereto and will also work if the target 102 moves for example along a trajectory that forms an angle in the range from 0° to 45° relative to the Z-axis. The sensor device of such a system may be configured for estimating a distance between the target 102 and the proximity sensor device 101, and/or for determining whether the target is closer than or further than a predefined distance Zp (see e.g. FIG. 20) from the sensor device 101.

But the present invention is not limited to systems wherein the target 102 is movable towards and away from the sensor device in the Z-direction, and can for example also be used in a system 150 where the target 102 is movable in a direction parallel to the PCB 103, e.g. from a first position wherein an orthogonal projection of the target 102 onto the PCB 103 does not overlap an orthogonal projection of the sensor device 101, to a second position wherein an orthogonal projection of the target 102 onto the PCB completely overlaps an orthogonal projection of the sensor device 101, as illustrated e.g. in **FIG. 1B****.**

For completeness, it is noted that the printed circuit board 103 preferably does not have a large conductive plane under the sensor chip, and that high AC current conducting wires are to be avoided in the vicinity of the sensor device 101, but these kinds of recommendations fall outside the scope of the present invention.

**FIG. 2** shows a high-level block-diagram of an illustrative example of a proximity sensor device 201, comprising two transmitter coils TX1, TX2 and two receiver coils RX1, RX2, and a switch 216 which is opened or closed depending on the position of a movable target 202 (e.g. a metal target) relative to the sensor device 201.

The two transmitter coils TX1, TX2 may electrically be connected in various ways, as will be described further in FIG. 11, e.g. in parallel. The two receiver coils RX1, RX2 may electrically be connected in various ways, as will be described further in FIG. 12, e.g. in series.

The sensor device 201 comprises at least one transmitter circuit 213 for exciting the transmitter coils TX1, TX2 with an alternating signal, e.g. having one or more frequencies in the range from 15 MHz to 30 MHz, or in the range from 20 MHz to 30 MHz. Preferably the two transmitter coils are excited synchronously and/or simultaneously. The transmitter circuit 213 may comprise a signal modulator. An example of a transmitter circuit will be illustrated in FIG. 15A, but the present invention is not limited hereto, and other transmitter circuits can also be used.

The sensor device 201 comprises at least one receiver circuit 214 connected to the receiver coils RX1, RX2. The receiver circuit 214 may comprise an amplifier and a synchronous demodulator.

The sensor device 201 further comprises an evaluation circuit 215 configured for interpreting the received signal(s) from the receiver coils, e.g. for determining a distance "dz" between the target and the proximity sensor device (e.g. as illustrated in FIG. 1A), and/or for determining whether the target is in a proximal position or a distal position with respect to the sensor device (e.g. as illustrated in FIG. 1B). An example of a receiver circuit and an evaluation circuit will be illustrated in FIG. 15B, but the present invention is not limited hereto, and other receiver circuits and/or evaluation circuits can also be used.

In the embodiment of FIG. 2, the sensor device 201 further comprises a switch 216 (e.g. a "normally closed switch" or a "normally open switch"), which is controlled by the evaluation circuit 215. In an embodiment, the switch 215 will be closed when the target 202 is relatively close to (or proximal to) the sensor device 201, and will be opened when the target is relatively far from (or distal from) the sensor device 201. In another embodiment, the switch 216 will be opened if the target 202 is relatively close to the sensor device 201, and will be closed if the target is relatively far from the sensor device.

The switch 216 may electrically connect or disconnect two terminals P1, P2. In an embodiment, the sensor device 201 has two dedicated terminals P1, P2 which are not connected to other voltage nodes inside the sensor device. In another embodiment, one of the nodes of the switch 216 may be internally connected to a reference voltage, e.g. Vdd or Gnd.

These are the most important blocks of the proximity sensor device 201, but in a practical implementation there may of course also be other blocks and/or components (not explicitly shown), such as for example: an oscillator circuit, clock dividers, phase locked loops (PLL), amplifier(s), comparator(s), modulator, demodulator, analog-to-digital converter (ADC), resistor(s), capacitor(s), diode(s), voltage stabiliser, digital processor, shift registers, a timer, non-volatile memory, serial interface, all of which are known in the art, and hence need not be further explained here.

If present, the non-volatile memory (not shown) may comprise for example a threshold value (e.g. the value Vth of FIG. 20) for determining whether the target is in a first (e.g. proximal) or a second (e.g. distal) position. This threshold value may be written in the non-volatile memory during a calibration procedure. The non-volatile memory may of course also comprise other values, e.g. for amplifier offset-compensation, etc.

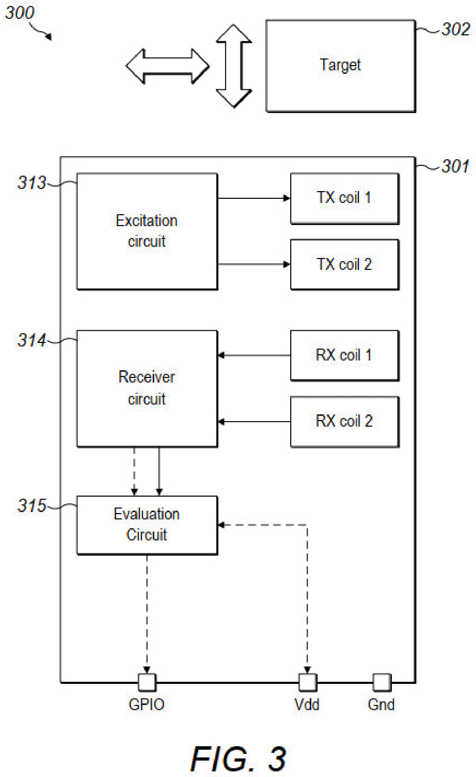

**FIG. 3** shows a high-level block-diagram of an illustrative example of another proximity sensor device 301, also comprising two transmitter coils TX1, TX2 and two receiver coils RX1, RX2, and an excitation circuit 313 and a receiver circuit 314, and an evaluation circuit 315. The sensor device 301 of FIG. 3 does not contain a switch 216 for selectively connecting or disconnecting two terminals P1, P2, but the evaluation circuit 315 provides a value or a signal indicative of the detected position of the conductive target 302, for example as a binary (i.e. digital) signal on a GPIO-pin (general purpose input/output pin), or as a PWM signal (pulse-width modulation), or as a serial bit-stream, or as an analog output current or as an analog output voltage, e.g. proportional to the detected distance (within a predefined range), or in any other suitable way.

**FIG. 4** shows a cross-sectional view of an illustrative example of a proximity sensor device 401 proposed by the present invention.

The proximity sensor device 401 comprises: a first coil arrangement comprising a first excitation coil (or transmitter coil) TX1 and a first receiver coil RX1 implemented in at least one first redistribution layer RDL1, RDL2, extending in a first and second direction X,Y.

The proximity sensor device 401 further comprises: a second coil arrangement comprising a second excitation coil (or transmitter coil) TX2 and a second receiver coil RX2 implemented in at least one second redistribution layer RDL3, spaced from the at least one first redistribution layer RDL1, RDL2 by at least 200 µm, or at least 250 µm, or at least 275 µm, or at least 300 µm, or at least 350 µm, or at least 400 µm, or at least 450 µm, or at least 500 µm measured in the Z-direction, perpendicular to the first and second direction X,Y.

The proximity sensor device 401 further comprises: a semiconductor substrate 10, e.g. a CMOS device, arranged in a space between the at least one first redistribution layer RDL1, RDL2 and the at least one second redistribution layer RDL3. The semiconductor substrate 10 comprises an excitation circuit 213, 313 configured for exciting the first and second excitation coil TX1, TX2, and comprises a receiver circuit 214, 314 configured for receiving one or more signals from the receiver coils RX1, RX2 (e.g. a combined signal of a series-connection of the two receiver coils), and comprises an evaluation circuit 215, 315 configured for determining a position (e.g. a distance value) or a value indicative of a position (e.g. a presence or an absence) of an electrically conductive target 102, 202, 302 that is movable towards and away from the proximity sensor device, based on said one or more signals.

The excitation circuit, receiver circuit and evaluation circuit are implemented on the "active surface" of the semiconductor substrate 10. The semiconductor substrate 10 also comprises an interconnection stack (not explicitly shown) and a plurality of contact pads 17 (sometimes also referred to as "bond pads").

In the example of FIG. 4, there are two RDL layers situated above the semiconductor substrate 10, namely: RDL1 which is mainly used as a routing or interconnection layer, and RDL2 which is mainly used for implementing two spirals: one spiral for the first transmitter coil TX1, and one spiral for the first receiver coil RX1, jointly referred to as "the first coils". (see also FIG. 6 for a top view of an illustrative example of these spirals, but the present invention is not limited hereto, and other spiral shapes can also be used).

In the example of FIG. 4, there is only one second RDL layer situated under the semiconductor substrate 10, namely: RDL3 which is mainly used for implementing two spirals: one spiral for the second transmitter coil TX2, and one spiral for the second receiver coil RX2, jointly referred to as "the second coils". Ends t2a, t2b, r2a, r2b (not explicitly shown in FIG. 4, but see e.g. FIG. 10B) of the second coils TX2, RX2 may be electrically connected to ends t1a, t1b, r1a, r1b of the first coils and/or to contact pads 17 of the semiconductor substrate 10 by means of through-vias 21 and/or interconnection paths formed in RDL1.

In the example of FIG. 4, the coils TX1, RX1, TX2, RX2 are shown with only 3 or 4 turns for illustrative purposes, but in practice, the number of turns may be smaller than 3 or larger than 4.

In the example of FIG. 4, the through-vias 21 are shown as through-mould vias (TMV), but other through-vias can also be used, for example through-glass vias (TGV) provided in a glass insert 20 (e.g. as illustrated in FIG. 9 or FIG. 10B, or FIG. 22B to FIG. 22I).

In the example of FIG. 4, there are through vias on both sides (left and right) of the semiconductor substrate 10, but that is not absolutely required, as will be explained further in FIG. 6 to FIG. 10B.

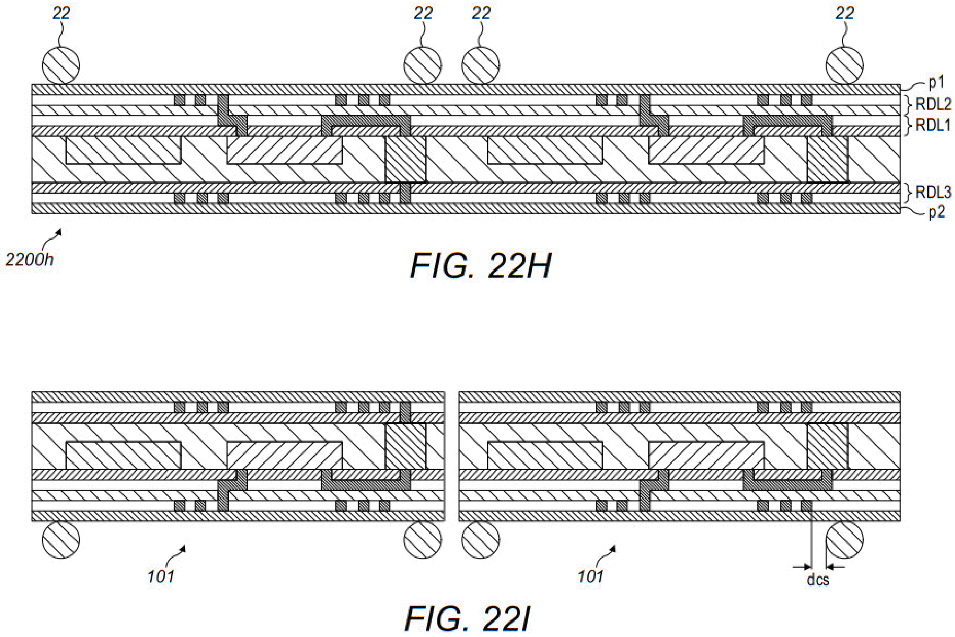

The sensor device 401 of FIG. 4 may also have a plurality of terminals (not explicitly shown) or solder balls or solder bumps 22. They are typically connected to contact pads 17 of the semiconductor substrate 10 by means of electrical paths implemented in the RDL-layers, but these connections are not shown in FIG. 4, in order not to overload the drawing. It is noted that the solder balls 22 may be omitted, and it suffices that the sensor device comprises a plurality of "contact terminals" that are exposed, e.g. by making a plurality of openings in the protection layer p1 or p2, as will be described further (see e.g. FIG. 22H). Such a sensor device can then be soldered on a printed circuit board having solder material.

In the example of FIG. 4, the spiral windings of RX1 are located inside the spiral windings of TX1, (see also FIG. 6), and the spiral windings of RX2 are located inside the spiral windings of TX2, but the present invention is not limited thereto, and it is also possible (although not preferred) to locate the transmitter coils inside the respective receiver coils.

While not shown in FIG. 4, but see e.g. FIG 8 to FIG. 10, the sensor device 401 may also comprise one or more passive fillers 24, e.g. made of a ceramic material or made of glass. These fillers may be used e.g. for improving mechanical stability of the structure.

In a variant of FIG. 4, (see e.g. FIG. 8 or FIG. 9), the sensor device has two RDL layers (labelled RDL1, RDL2) above the semiconductor substrate 10; and two RDL layers below the semiconductor substrate 10, including a layer RDL3 mainly used as a routing layer, and a layer RDL4 mainly used for implementing the second coils TX2 and RX2. While a sensor device with four RDL layers (e.g. as illustrated in FIG. 5B) requires extra production steps (as compared to a device with only three RDL layers as illustrated in FIG. 5A), it also provides extra design or layout flexibility.

In another or further variant of FIG. 4, the terminals and/or solder balls 22 are located on the bottom side of the semiconductor substrate 10.

As can be seen, the size of the coils may be larger than the size of the semiconductor substrate 10. This offers the advantage that the semiconductor substrate 10 can be designed and optimized (e.g. cost optimized) differently and independently from the dimensions of the coils, and allows e.g. that the dimensions of the coils are optimized for RF performance.

It is noted that the semiconductor substrate 10 of FIG. 4 is located substantially in the middle of the device 401, but that is not absolutely required, see e.g. FIG. 10B.

**FIG.** 5A shows an abstract representation of FIG. 4. As can be seen, this sensor device 501a has three RDL layers, two above, and only one below the semiconductor substrate 10.

**FIG. 5B** shows a variant of FIG. 5A for a sensor device having four RDL layers, two above, and two below the semiconductor substrate 10.

It is noted that FIG. 4, FIG. 5A and FIG. 5B show solders balls 22 located above the first protection layer p1, but does not explicitly show that they are electrically connected to bond pads 17 of the semiconductor substrate 10, and does not show openings made in the protection layer p1, and does not show that these openings are metalized (e.g. UBM - Under Bump Metallization), etc. Such details are well known in the art, and do not need to be described in detail here.

**FIG. 6** shows an illustrative example of a possible layout (or top view) of a transmitter coil TX1 and receiver coil RX1 as may be used in embodiments of the present invention. In the example shown, the TX1 coil has approximately 4.0 turns, and the RX1 coil has approximately 3.5 turns, but in practice the TX1 coil and RX1 may have for example from 10 to 50 turns, or from 15 to 40 turns, or from 20 to 30 turns. The TX1 coil has two ends t1a, t1b, and the RX1 coil has two ends r1a, r1b. In the example shown, the spirals of TX1 and RX1 have a square shape, but the present invention is not limited hereto, and other shapes, e.g. a rectangular shape, a circular shape, a polygonal shape can also be used.

Everything mentioned for the first coils RX1, TX1 is also applicable to the second coils RX2, TX2.

In preferred embodiments, the dimensions of TX1 and TX2 are substantially the same (e.g. outer periphery, inner periphery, same cross-sectional width and height). Likewise, preferably the dimensions of RX1 and RX2 are substantially the same (e.g. outer periphery, inner periphery, same cross-sectional width and height).

In preferred embodiments, the number NR2 of windings of RX2 is substantially equal to the number NR1 of windings of RX1 plus or minus 2, or plus or minus 1, (written mathematically: NR2=NR1 ±2, or NR2=NR1 ±1); and the number NT2 of windings of TX2 is substantially equal to the number NT1 of windings of TX1, plus or minus 2, or plus or minus 1, (written mathematically: NT2=NT1 ±2, or NT2=NT1 ±1). Small differences between the number of turns of TX1, TX2 allows to position the end points t1a, t1b, t2a, t2b of the coils TX1, TX2 at different locations. Likewise, small differences between the number of turns of RX1, RX2 allows to position the end points r1a, r1b, r2a, r2b of the coils RX1, RX2 at different locations, which can be used e.g. to avoid the need for four RDL layers (e.g. as illustrated in FIG. 10); and/or allows to locate the end r2a, r2b, t2a, t2b closer together such that e.g. only a single passive insert 20 with through-vias 21 is required instead of multiple (e.g. as illustrated in FIG. 9 and FIG. 10).

It is noted that the windings shown in FIG. 6 can be implemented in a single RDL layer (e.g. RDL2 in FIG. 4 and FIG. 5A and FIG. 5B), but if the connection to end t1a crosses some of the windings, a second layer is needed (e.g. RDL1 in FIG. 4 and FIG. 5A and FIG. 5B). The same is true for the windings of TX2 and RX2, which is why the structure of FIG. 5B has four RDL layers. Since the structure of FIG. 5A has only three RDL layers, the end points t1a, t1b, r1a, r1b of the first coils TX1 and RX1 may be connected by paths that cross the windings of TX1 and/or RX1, but the end points t2a, t2b, r2a, r2b of the second coils cannot. This will be explained further in FIG. 10A and FIG. 10B.

**FIG.** 7 shows an illustrative example of a top view of a possible arrangement of a semiconductor substrate 10 and a plurality of solder balls 22, relative to a first transmitter coil TX1 and a first receiver coil RX1 implemented in an RDL-layer RDL2 situated above the semiconductor substrate 10, e.g. as also illustrated in FIG. 4, although the positions of the end points t1a, t1b, r1a, r1b may be slightly changed for illustrative purposes.

Preferably the solder balls 22 or solder bumps are spaced from the coil windings by a distance dcs of at least 100 µm, or at least 150 µm, or at least 200 µm, or at least 250 µm.

FIG. 7 does not show the second set of coils TX2, RX2, and does not show their connection(s) to the first coils TX1, RX1 or to contact pads 17 of the semiconductor substrate 10, which will be described further, e.g. in FIG. 8 to FIG. 10B.

**FIG. 8** shows an illustrative example of a possible exploded view of a proximity sensor device having four RDL layers and a plurality of trough-vias 21 situated at various locations, resulting in a structure similar to that of FIG. 5B.

In the example shown in FIG. 8, several layers are shown:
- RDL2 layer comprises mainly the windings of the coils TX1 and RX1. For completeness, it is noted that the horizontal line portion connected to t1a is actually not located in RDL2 but in RDL1.
- RDL1 layer is a routing layer comprising connections similar to the ones shown in FIG. 7 (between the solder balls and the contact pads 17), but also additional connections, e.g. connections to upper ends 21t of the through-vias 21, for connection with the second coils RX2, TX2. The RDL1 layer is shown as a rectangular block for illustrative purposes, but in practice comprises a dielectric layer with a plurality of vias, and a conductive layer situated on top of the dielectric layer to form a plurality of conductive wires.

- RDL3 layer is also a routing layer.
- RDL4 layer comprises mainly the windings of the coils TX2 and RX2. For completeness, it is noted that the horizontal line portion connected to t2a is actually not located in RDL4 but in RDL3.
- the space between RDL1 and RDL3 comprises: the semiconductor substrate 10, a plurality of through-vias 21 (e.g. in the form of Through-Mold-Vias, TMV; or in the form of Through-Glass-Vias, TGV), and may optionally also comprise other components such as a passive filler block 24, and may optionally also comprise one or more passive components, such as discrete capacitors or resistors, etc., and comprises a mould compound 23, e.g. an epoxy (not shown in FIG. 8, but see e.g. FIG. 22C).

In the example of FIG. 8, the layout of the windings of the first coils TX1, RX1 is identical to the layout of the windings of the second coils TX2, RX2, and their ends t1a, t1b, r1a, r1b are located exactly above each other, for illustrative purposes, but as already mentioned above, one or more of these ends may be shifted. It is noted that the positions of the first ends t1a, t1b, r1a, r1b and the second ends t2a, t2b, r2a, r2b may be shifted relative to one another depending on how the transmitter coils TX1, TX2 are connected to each other, e.g. in series or in parallel or otherwise (see e.g. FIG. 11 and FIG. 14) and/or depending on how the receiver coils RX1, RX2 are connected to each other, e.g. in series or in parallel or otherwise (see e.g. FIG. 12 and FIG. 14).

FIG. 8 illustrates that it is not absolutely required to group the through-vias 21, but they can be implemented as individual through-vias for interconnecting portions of RDL1 with portions of RDL3.

FIG. 8 shows the main parts of the inductive proximity sensor device, but not all. For example, FIG. 8 does not show: a first protection layer p1 situated above RDL2, a second protection layer p2 situated under RDL4, a plurality of terminals and/or solder balls, optional passive components such as a discrete capacitor or resistor, etc. As described above, the solder balls may be situated on top of RDL2, or under RDL4. It is an advantage if the solder balls are situated on top of RDL2, because otherwise additional through-vias would be required for connecting these solder balls.

FIG. 8 shows one optional filler block 24, but of course the device may comprise no filler blocks, or at least two filler blocks 24, arranged on opposite sides of the semiconductor substrate (e.g. one on the left, and one on the right of the semiconductor substrate 10 shown in FIG. 8). These filler blocks may improve mechanical stability.

**FIG. 9** shows a variant of FIG. 8, also comprising four RDL layers and a plurality of through-vias 21, but in this example, the through-vias 21 are located closely together. More specifically, the structure of FIG. 9 comprises one or more but preferably only one passive substrate 20, e.g. a glass substrate or a ceramic substrate, comprising a plurality of through-vias 21, e.g. in the form of through-glass-vias (TGV). The height H20 of this passive insert may e.g. be a value in the range from 250 µm to 500 µm, or in the range from 300 µm to 450 µm. The larger the value of H20, the smaller the amount of cross-talk between the first set of coils and the second set of coils, e.g. from TX1 to RX2 and from TX2 to RX1.

In the particular example shown in FIG. 9, the ends t2a, t2b, r2a, r2b of the second coils TX2, RX2 are deliberately moved closely together, e.g. towards a zone between the windings of TX2 and the windings of RX2. When comparing the second coils of FIG. 9 with those of FIG. 8, it will be see that this may cause the number of windings of TX2 and/or RX2 to be slightly increased or decreased, but this is not critical for the invention to work.

In the example shown in FIG. 9, the coils TX1 and RX1 are identical to the coils TX2 and RX2, and the first ends t1a, t1b, r1a, r1b of the first coils TX1, RX1 are situated exactly above the second ends of the second coils, but that is not absolutely required, and for example the layout of the first coils TX1, RX1 of FIG. 8 could also be used, or another variation thereof.

In the example of FIG. 9, the end points t2a, t2b, r2a, r2b are arranged on a single row, but that is not absolutely required, and they could e.g. also be arranged in two rows.

Everything else mentioned for FIG. 8 is also applicable here, mutatis mutandis.

**FIG. 10A** shows a possible layout (in top view) of a first set of coils TX1, RX1 and a second set of coils TX2, RX2, having substantially the same shape, but some or all of the first ends t1a, t1b, r1a, r1b are located at different locations than the second ends t2a, t2b, r2a, r2b. For example, t1a and t2a are not located exactly above each other, nor are t1b and t2b, nor are r1a and r2a, nor are r1b and r2b.

Importantly, r2a is located inside RX2, r2b and t2b are located outside RX2 but inside TX2, and t2a is located outside of TX2. By doing so, no second routing layer is required to cross the windings of TX2 and/or RX2.

**FIG. 10A** also shows possible dimensions for the RX2 and TX2 coils, but of course this is an example only, and the present invention is not limited to this example. In this example, the inner periphery of RX2 has a size of about 1.55 mm, the outer periphery of RX2 has a size of about 2.20 mm, the inner periphery of TX2 has a size of about 2.37 mm, and the outer periphery of TX2 has a size of about 3.00 mm. For these coil dimensions, and for these particular locations of the second ends t2a, t2b, r2a, r2b a single glass insert 20 having a length L20 of about 2.20 mm, and a width W20 of about 2.00 mm, can easily provide four through-vias 21 to connect these four ends t2a, t2b, r2a, r2b to the first routing layer RDL1 situated above the semiconductor substrate (not shown in FIG. 10A, but see e.g. FIG. 10B). The skilled person having the benefit of the present disclosure will understand that it is also possible to move the second ends even closer together (e.g. by shifting them in the X-direction), such that the length L20 can be further reduced, e.g. to a value smaller than or equal to 1.00 mm, or even smaller than or equal to 0.75 mm, or even smaller than or equal to 0.50 mm. In the example of FIG. 10A, the envisioned insert 20 has four through-vias, but there may be more than four vias, e.g. seven or eight through-vias, or more than eight.

**FIG. 10B** shows a variant of FIG. 8 and FIG. 9, comprising a first set of coils TX1, RX1, e.g. the same set TX1, RX1 as used in FIG. 8, or the same set TX1, RX1 as used in FIG. 9, or the same set TX1, RX1 as illustrated in FIG. 10A (upper part), or a variation of any of these sets; and comprising the second set of coils TX2, RX2 of FIG. 10A (lower part) or a variation thereof (e.g. wherein the second ends t2a, t2b, r2a, r2b are shifted in the X-direction closer towards each other); and comprising the passive insert 20 (e.g. glass insert) with the plurality of through-vias 21, e.g. the insert 20 shown FIG. 10A (bottom part), or a variant thereof having different dimensions L20, W20 and/or another number of through-vias 21, (e.g. from 2 to 12, or from 3 to 10, or from 4 to 8 through-vias).

Interestingly, the structure of FIG. 10B has only three RDL layers: RDL1 and RDL2 above the semiconductor substrate, and RDL3 under the semiconductor substrate, wherein RDL1 is used mainly as routing layer, RDL2 is used mainly for implementing the spiral windings of TX1 and RX1, and RDL3 is used mainly for implementing the spiral windings of TX2 and RX2. Thus, the routing layer under the semiconductor substrate (e.g. RDL3 of FIG. 9) can be omitted.

FIG. 10B also illustrates that the semiconductor substrate 10 does not need to be situated in the centre of the structure in the X and Y-direction, but may be shifted for example to the positive Y-direction.

Everything else mentioned above for FIG. 8 and FIG. 9 is also applicable here, mutatis mutandis. For example, one or more filler blocks 24 may be provided, e.g. for mechanical stability.

**FIG. 11** shows four examples of how the two transmitter coils TX1 and TX2 may be interconnected: (a) in series, (b) in anti-series, (c) in parallel, or (d) in anti-parallel.

While it is possible to excite the two transmitter coils separately using two different excitation signals, in preferred embodiments of the present invention, the two transmitter coils TX1, TX2 are interconnected and excited simultaneously using a single excitation signal Vexc.

The magnetic fields generated by TX1 and TX2 of the series and parallel connection of FIG. 11(a) and FIG. 11(c) generate a combined magnetic field in the receiver coils RX1 and RX2, that is larger than the individual magnetic fields generated by each transmitter coil separately due to constructive interference.

The magnetic fields generated by TX1 and TX2 of the anti-series and anti-parallel connection of FIG. 11(b) and FIG. 11(d) generate a combined magnetic field in the receiver coils RX1 and RX2, that is smaller than the individual magnetic fields generated by each transmitter coil separately, due to destructive interference.

**FIG. 12** shows four examples of how the two receiver coils RX1 and RX2 may be interconnected: (a) in series, (b) in anti-series, (c) in parallel, or (d) in anti-parallel.

While it is possible to receive and process the signals obtained from the two receiver coils RX1, RX2 separately, in preferred embodiments of the present invention, the receiver coils are interconnected, and the combined signal Vout is further processed for determining a position of the target (e.g. a distance dz as illustrated in FIG. 1A) or a position in the X or Y position (e.g. related to full overlap or no overlap, e.g. as illustrated in FIG. 1B)

**FIG. 13** shows a preferred combination, wherein the two transmitter coils TX1, TX2 are connected in parallel, e.g. as in FIG. 11(c) and the two receiver coils RX1, RX2 are connected in series, e.g. as in FIG. 12(a). The transmitter coils can be excited by applying an excitation voltage over the nodes TXP, TXN. An output voltage Vout can be be measured over the voltage nodes RXP, RXN.

As shown, a capacitor CTx can also be connected in parallel with the transmitter coils. This capacitor may be implemented inside the semiconductor substrate 10, but could also be provided as a discrete capacitor outside of the semiconductor substrate 10. As also shown, the node that interconnects the two receiver coils RX1, RX2 may be connected to a common mode voltage Vcm. As an example, if the supply voltage of the proximity sensor device is about 5.0 Volt, the common mode voltage may be set at about 2.5 Volt, but of course, other values for the supply voltage and for the common mode voltage can also be used.

**FIG. 14A to FIG. 14G** are schematic representations showing possible combinations of coils being wound in a clockwise (cw) or counter-clockwise (ccw) directions.

The spirals of the coils TX1, RX1, TX2, RX2 shown in the figures above (FIG. 1 to FIG. 13) are all wound in a clockwise (cw) direction, but the present invention is not limited thereto, and it is also possible to wind some or even all of the coils in a counter-clock-wise (ccw) direction.

**FIG. 14A** shows an embodiment wherein the windings of TX1 and RX1 and TX2 and RX2 are wound in a clockwise manner (cw). In this embodiment, TX1 and TX2 are preferably electrically connected in parallel or in series, e.g. as illustrated in FIG. 11(a) or FIG. 11(c), and RX1 and RX2 are preferably electrically connected in series or in anti-parallel, e.g. as illustrated in FIG. 12(a) or FIG. 12(d).

**FIG. 14B** shows an embodiment wherein the windings of TX1 and RX1 and RX2 are wound in a clockwise manner (cw), and the windings of TX2 are wound in a counter-clockwise manner (ccw). In this embodiment, TX1 and TX2 are preferably connected in anti-parallel or in anti-series, while RX1 and RX2 are preferably connected in parallel or in anti-series.

**FIG. 14C** shows an embodiment wherein the windings of TX1 and RX1 and TX2 are wound in a clockwise manner (cw), and the windings of RX2 are wound in a counter-clockwise manner (ccw). In this embodiment, TX1 and TX2 are preferably connected in parallel or in series, while RX1 and RX2 are preferably connected in anti-series or in parallel.

**FIG. 14D** shows an embodiment wherein the windings of TX1 and RX1 are wound in a clockwise manner (cw), and the windings of TX2 and RX2 are wound in a counter-clockwise manner (ccw). In this embodiment, TX1 and TX2 are preferably connected in anti-parallel or in anti-series, while RX1 and RX2 are preferably connected in series or in anti-parallel.

**FIG. 14E** shows an embodiment wherein the windings of TX1 and TX2 and RX2 are wound in a clockwise manner (w), and the windings of RX1 are wound in a counter-clockwise manner (ccw). In this embodiment, TX1 and TX2 are preferably connected in parallel or in series, while RX1 and RX2 are preferably connected in anti-series or in parallel.

**FIG. 14F** shows an embodiment wherein the windings of RX1 and TX2 and RX2 are wound in a clockwise manner (cw), and the windings of TX1 are wound in a counter-clockwise manner (ccw). In this embodiment, TX1 and TX2 are preferably connected in anti-parallel or in anti-series, while RX1 and RX2 are preferably connected in anti-series or in parallel.

**FIG. 14G** shows an embodiment wherein the windings of TX2 and RX2 are wound in a clockwise manner (cw), and the windings of TX1 and RX1 are wound in a counter-clockwise manner (ccw). In this embodiment, TX1 and TX2 are preferably connected in anti-parallel or in anti-series, while RX1 and RX2 are preferably connected in series or in anti-parallel.

For completeness it is noted that an embodiment wherein the windings of TX1, RX1, TX2 and RX2 are wound in a counter-clockwise (ccw) direction, is functionally equivalent to the embodiment illustrated in FIG. 14A.

Likewise, an embodiment wherein the windings of TX1, RX1 and RX2 are wound in a counter-clockwise (ccw) manner, and the windings of TX2 are wound in a clockwise (cw) manner, is functionally equivalent to the embodiment illustrated in FIG. 14B.

Similar statements can be made for FIG. 14C to FIG. 14G.

**FIG. 15A** shows a block-diagram of a transmitter circuit that may be used to excite the transmitter coils TX1, TX2, for example the transmitter circuit shown in FIG. 13. This is only one possible implementation of an excitation circuit 213, 313. The circuit comprises a full bridge, driven by a clock signal CLK and its logical inverse CLKB. It may optionally further comprise a current limiter 18 or a controlled current source configured for limiting the current that goes into the TX1 and TX2 coils. This circuit is very well known in the art, hence does not need to be described further, and is provided for completeness only.

**FIG. 15B** shows an illustrative example of a receiver circuit 1514 and an evaluation circuit 1514 connected to an output of a series-connection of the two receiver coils Rx1, Rx2 (as in FIG. 13). The receiver coils provide a differential voltage signal Vout induced by an alternating flux received by the receiver coils RX1, RX2, due to their inductive coupling with the transmitter coils TX1 and TX2.

The receiver coil RX1 will sense an alternating field generated by TX1 (which is located in the same plane as RX1, e.g. RDL2) and will also sense an alternating field generated by TX2 which is located in a plane e.g. RDL4 situated at a distance from the plane RDL2, e.g. a distance in the range from about 200 µm to about 500 µm. Likewise, the coil RX2 will sense a first alternating field generated by TX2 which is located in the same plane as RX2 (e.g. RDL4), and will also sense a second alternating field generated by TX1, which is located in another plane (e.g. RDL2) situated at said distance from the plane that contains RX2.

Since the coils TX1 and TX2 have substantially the same dimensions and substantially the same number of turns (e.g. NTX1=26±1, and NTX2=26±1), apart from minor differences regarding the location of their ends as explained above in FIG. 8 to FIG. 10A, they will have approximately the same inductances LTX1 and LTX2. Likewise, since the coils RX1 and RX2 have substantially the same dimensions and substantially the same number of turns (e.g. NRX1=25±1, and NRX2=25±1), apart from minor differences regarding the location of their ends as r1a, r1b, r2a, r2b explained above in FIG. 8 to FIG. 10A, they will have approximately the same inductances LRX1 and LRX2, and the magnetic coupling between TX1 and RX1 will be approximately the same as the magnetic coupling between TX2 and RX2, and the magnetic cross-coupling between TX1 and RX2 will be approximately the same as the magnetic cross-coupling between TX2 and RX1.

If the conductive target 102 is absent or located relatively far away from the proximity sensor device, the coils RX1 and RX2 will receive approximately the same signal, and hence the voltage difference Vout1 of their series connection will be substantially equal to zero, and hence also the amplified and demodulated signal Vout2 will be substantially equal to zero (e.g. smaller than 100 µV).

If the conductive target 102 is relatively close to the proximity sensor device, (e.g. moved to a distance dz smaller than a predefined distance in the system of FIG. 1A, or moved to fully overlap the sensor device 101 in the system of FIG. 1B), the conductive target 102 will sense the combined magnetic field generated by TX1 and TX2, which will cause eddy currents to flow, which will induce a third magnetic field originating from the movable target, but since one of the receiver coils is closer to the movable target than the other (e.g. 200 to 500 µm closer), the magnetic field generated by the movable target will be sensed differently by the two receiver coils RX1 and RX2, such that the voltages over the receiver coils RX1 and RX2 will be slightly different, and the voltage difference Vout1 of the series connection will be different from zero, and hence also the amplified and demodulated signal Vout2 will be quite different from zero (e.g. a value in the range from 200 to 800 µV), dependent on the distance between the proximity sensor device 101 and the movable target 102.

This measurement principle, namely that (i) the movable target is absent or far away, if the output voltage Vout is small, e.g. smaller than a predefined threshold value; and (ii) that the movable target is relatively close to the proximity sensor device, if the output voltage Vout is relatively large, e.g. larger than a predefined threshold value; is used in all embodiments of the present invention, irrespective of how the transmitter coils or receiver coils are interconnected.

Referring back to the circuit of FIG. 15B, the difference signal Vout is amplified by a differential amplifier (Amp), and then mixed or demodulated or down-converted using a reference signal "Ref" (e.g. a sinusoidal signal having a predefined frequency, e.g. obtained from the RCO oscillator, optionally followed by a PSK modulator). The demodulated signal may then be rectified (not shown) and/or lowpass filtered (LPF), to yield a signal indicative of the amount of flux received by the receiver coils.

This signal may then be further processed, such as for example compared to at least one threshold voltage Vth in the evaluation circuit 1515. The output of the comparator may be used to operate a switch 216 as shown in FIG. 2, or may be output as an analogue signal, or may be digitised and output as a digital signal indicative for the position of the target, e.g. via a general input-output pin (GPIO) or via a serial communication bus (not shown), via a two-wire interface, etc, e.g. as illustrated in FIG. 3.

It is noted that the present invention is not limited to the particular excitation circuit shown in FIG. 15A, or the particular receiver circuit and evaluation circuit shown in FIG. 15B, and other suitable circuits can be also be used.

**FIG. 16 to FIG. 18** show a few illustrative examples to illustrate that the dimensions of the semiconductor substrate 10 and the dimensions of the coils TX1, RX1, TX2, RX2 are highly unrelated. In these drawing, abstraction is made of the individual turns or windings, and the spiral shapes are shown as a rectangular ribbon. It was already clear from FIG. 4 to FIG. 5B, and FIG. 8 to FIG. 10B that there is no relation between the thickness of the coils and the thickness of the semiconductor substrate, but FIG. 16 to FIG. 18 will make clear that there is also no relation between the length and width (measured in the X and Y direction) of the semiconductor substrate, and the length and width (measured in the X and Y direction) of the areas occupied by the spiral shape of the transmitter coils TX1, TX2 or the receiver coils RX1, RX2. The present invention is especially aimed at proximity sensor devices having transmitter coils having an outer periphery PoTx that is larger than an outer periphery of the semiconductor substrate.

**FIG. 16** shows an example wherein an orthogonal projection (along the Z-direction) of the outer periphery of the semiconductor substrate 10 completely fits inside the inner periphery PiRx of the receiver coils.

**FIG. 17** shows an example wherein an orthogonal projection (along the Z-direction) of the outer periphery of the semiconductor substrate 10 has a length (measured in the Y-direction) which is larger than the length of the inner periphery PiRx of the receiver coils, but smaller than the length of outer periphery PoRx of the receiver coils, and has a width (measured in the X-direction) which is larger than the width of the outer periphery PoRx of the receiver coils but smaller than the width of the inner periphery PiTx of the transmitter coils.

**FIG. 18** shows an example wherein an orthogonal projection (along the Z-direction) of the outer periphery of the semiconductor substrate 10 has a length (measured in the Y-direction) which is larger than the length of the outer periphery PiRx of the receiver coils, but smaller than the length of the inner periphery PiTx of the transmitter coils, and has a width (measured in the X-direction) which is larger than the width of the outer periphery PoRx of the receiver coils but smaller than the width of the inner periphery PiTx of the transmitter coils.

Another example was also given in FIG. 10A, where the spirals of the TX coils and the RX coils have a square shape. The semiconductor substrate of FIG. 10B may for example have a length in the range from 1.2 mm to 1.8 mm, and a width in the range from 0.7 mm to 1.3 mm.

It is explicitly pointed out that these are mere examples, and the present invention is not limited hereto.

**FIG. 19** shows an illustrative example of a typical signal strength curve (before amplification, demodulation and filtering) of the combined signal Vout1 as can be obtained from the receiver coils (e.g. the series connected receiver coils RX1, RX2 shown in FIG. 13 and FIG. 15B) as a function of distance dz between the movable target 102 and the proximity sensor device 101, for a proximity sensor device as described above, having coils with dimensions as described in FIG. 10A, wherein the RDL2 and RDL4 layers are spaced apart by approximately 300 µm, when the transmitter coils are excited with an excitation signal having an amplitude of about 5V.

**FIG. 20** shows an illustrative example of a typical signal strength curve of a signal Vout2, as can be derived from the signal Vout1 of FIG. 19 after amplification, demodulation and rectification. FIG. 20 also shows that the signal Vout2 can be compared to a threshold value Vth, in order to determine whether the movable target is closer than, or further than a predefined distance Zp from the proximity sensor device.

**FIG. 21** shows a flowchart of a method 2100 of producing a proximity sensor device 101. The method comprises the steps of:
a) providing in step 2101 a carrier wafer 30;
b) applying in step 2102 a removable or releasable tape 31 (e.g. a thermal release tape or a laser release tape) on the carrier wafer 30;
c) placing in step 2103 one or more components on the removable or releasable tape, the one or more components comprising at least: a semiconductor substrate 10 (e.g. cmos substrate) and optionally one or more passive inserts 20 (e.g. a passive silicon substrate, or a ceramic substrate or glass substrate) comprising a plurality of through-vias 21;
d) overmolding in step 2104 the wafer with a molding compound (e.g. an epoxy) thereby forming a reconstituted wafer;
e) back-grinding in step 2105 the reconstituted wafer;
x) optionally making in step 2106 a plurality of openings (e.g. by drilling and/or using a laser) in the moulding compound extending to the removable or releasable tape, and filling them at least partially with a conductive material (e.g. only the sidewalls);
f) releasing in step 2107 the carrier wafer and the removable or releasable tape from the reconstituted wafer;
g) forming in step 2108 two or more first redistribution layers (e.g. RLD1 and RDL2 in the examples of FIG. 5A and FIG. 5B) on a first side of the reconstituted wafer, in electrical connection with contact pads 17 or contact areas of the semiconductor substrate 10 and/or in electrical connection with top sides 21t of said through-vias 21, wherein the first RDL layers comprise a first transmitter coil (TX1) and a first receiver coil (RX1);
h) forming in step 2109 one or more second redistribution layers (e.g. RLD3 and RDL4 in the example of FIG. 5B; or only RDL3 in the example of FIG. 5A) on a second side of the reconstituted wafer, opposite the first side, in electrical connection with bottom sides 21b of said through vias 21, wherein the second RDL layer(s) comprise a second transmitter coil (TX2) and a second receiver coil (RX2);
i) optionally adding in step 2110 solder balls or solder bumps on top of the first or second redistribution layer(s);
j) singulating in step 2111 the reconstituted wafer.

It is noted that, in practice, a different order of the steps may be followed, for example, it is possible to perform step h) before performing step g).

Step g) may further comprise: adding a first passivation layer p1, e.g. on top of RDL2.

Step g) may further comprise: wherein the first RDL layers further comprise a plurality of terminal areas in electrical connection with one or more contact areas 17 of the semiconductor substrate, and making openings in the first passivation layer p1 for making electrical contact with these terminal areas, and optionally providing UBM (Under Bump Metallization) on top of these terminal areas, and optionally providing solder balls 22 on top of the UBM.

Step h) may further comprise: adding a second passivation layer p2, e.g. on top of RDL4.

Step h) may further comprise: wherein the second RDL layers further comprise a plurality of terminal areas in electrical connection with one or more contact areas 17 of the semiconductor substrate, and making openings in the second passivation layer p2 for making electrical contact with these terminal areas, and optionally providing UBM (Under Bump Metallization) on top of these terminal areas, and optionally providing solder balls 22 on top of the UBM.

In an embodiment, step c) further comprises: placing one or more filler blocks (e.g. passive silicon substrate, ceramic substrate or glass substrate) on the thermal release tape.

In an embodiment, step c) further comprises: placing one or more discrete passive components selected from the group consisting of a diode, a resistor, a capacitor on the removable or releasable tape. They can be electrically connected during step g).

It is noted that the through-vias can be made in various manner, for example as Through-Glass-Vias (TGV) or as Through-Mould-Vias (TMV).

In case of Through-Glass-Vias, step c) comprises: placing one or more components on the removable or releasable tape, the one or more components comprising at least: a semiconductor substrate 10 (e.g. cmos substrate) and one or more passive inserts 20 (e.g. passive silicon substrate, or ceramic substrate or glass substrate) comprising a plurality of through-vias 21; and step e) comprises: back-grinding the reconstituted wafer, thereby exposing bottom sides 21b of said through-vias. It is noted that step f) can be omitted in this case;

In case of Through-Mould-Vias, step c) comprises: placing one or more components on the removable or releasable tape , the one or more components comprising at least: a semiconductor substrate 10 (e.g. a CMOS substrate); and step e) comprises: back-grinding the reconstituted wafer; and step x) comprises: making a plurality of openings in the moulding compound extending to the removable or releasable tape, and filling them at least partially (e.g. by metalizing the sidewalls of the openings) with a conductive material.

**FIG. 22A** to **FIG. 22I** show examples of devices obtained after performing various steps of the method of FIG. 21. More specifically,

**FIG. 22A** shows a carrier wafer 30 with a removable or releasable tape 31, as can be obtained by steps a) and b) of the method of FIG. 21;

**FIG. 22B** shows the wafer of FIG. 22A after placing one or more components, oriented "face-down" on the removable or releasable tape in step 2103, as described in step c) of FIG. 21. The one or more components include at least a semiconductor substrate 10, and optionally also a passive insert 20 comprising a plurality of through-vias 21, and optionally also a passive filler block 24;

**FIG. 22C** shows a reconstituted wafer as can be obtained after overmolding the wafer of FIG. 22B with a molding compound 23, as described in step d) of FIG. 21.

**FIG. 22D** shows the reconstituted wafer of FIG. 22C after back-grinding, as described in step e) of FIG. 21; and/or after making a plurality of openings in the moulding compound reaching to the removable or releasable tape 31, and filling these openings at least partially (e.g. only the sidewalls) with a conductive material, as described in step x) of FIG. 21. In the example shown in FIG. 22D, the through vias 21 are through-glass vias (TGV) provided in a glass insert 20, but as explained above, through-vias can also be made in the mold compound 23 itself. In each case, after performing step e) and/or x) the bottom sides 21b of the through-vias 21 are exposed.

**FIG. 22E** shows the reconstituted wafer of FIG. 22D after releasing the carrier wafer 30 and the removable or releasable tape 31, as described in step f) of FIG. 21, thereby exposing the top sides 21t of the through-vias 21, and also the contact areas 17 of the semiconductor substrate 10, and (if present), also contact areas of passive components (such as diodes, resistors, capacitors), etc.;

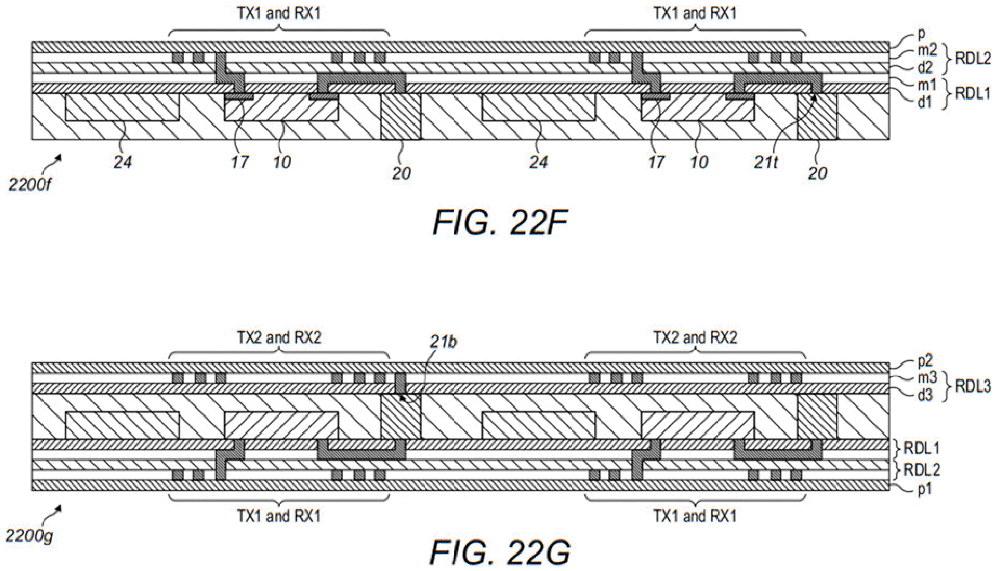

**FIG. 22F** shows the reconstituted wafer of FIG. 22E after forming two or more first redistribution layers (e.g. RDL1, RDL2) on a first side of the wafer (the side that was in contact with the removable and releasable tape), and after adding a first passivation layer p1. Each RDL layer comprises a dielectric layer and a conductive layer. The dielectric layer may comprise vias. The conductive layer may be patterned to form a plurality of electrical wires and/or terminal areas (not shown). Some of the wires of RDL1 are in electrical connection with contact areas 17 of the semiconductor substrate 10, and/or with top sides 21t of said through-vias 21. The RDL2 layer comprises windings forming a first transmitter coil TX1 and a first receiver coil RX1. (only a small number of turns of each coil is shown, in order not to overload the drawings).

**FIG. 22G** shows the wafer of FIG. 22F after forming one or more second redistribution layers (e.g. a single second RDL layer RDL3 as shown in FIG. 5A, or two second RDL layers RDL3, RDL4 as shown in FIG. 5B). The single RDL3 layer, or the RDL4 layer may comprise windings forming a second transmitter coil TX2 and a second receiver coil RX2. End points t2a, t2b, r2a, r2b of the second coils (not shown in FIG. 22G, but see e.g. FIG. 8 to FIG. 10B) are connected directly (e.g. if no second routing layer is present) or indirectly (e.g. if a second routing layer is present, via routing wires of this routing layer) to bottom sides 21b of through-vias 21. Only one such connection is shown in FIG. 22G, in order not to overload the drawings.

**FIG. 22H** shows the wafer of FIG. 22G after adding a plurality of solder balls or solder bumps 22 on top of the first redistribution layers RDL1, RDL2. As described above, these solder balls (if added) are preferably added on top of UBM (Under Bump Metallizations), which are added on top of "Terminal areas" (not shown) which may also be provided in RDL2, and which may be electrically connected to contact pads 17 of the semiconductor device 10 by means of electrical paths through the first routing layer RDL1. Thus, some or all of these terminal areas and the solder balls 22 (if provided) are in electrical connection with contact areas 17 of the semiconductor substrate 10, but these connections are not explicitly shown.

**FIG. 22I** shows two proximity sensor devices 101 as can be obtained after singulating the wafer of FIG. 22H. In practice the number of proximity sensor devices that can be obtained from a single reconstituted wafer is much higher than two, but only two are shown in order not to overload the drawings.

It is noted that the "interconnection stack" and the "contact pads" are integral part of the semiconductor substrate that is mounted "face-down" on the removable or releasable tape in FIG. 22B. The "interconnection" stack is formed on the semiconductor wafer before the semiconductor wafer is diced in a plurality of individual chips. The "interconnection stack" is not explicitly shown, but does not extend beyond the area defined by the upper surface of the semiconductor substrate. The RDL layers on the other hand, do extend beyond the area defined by the upper surface of the semiconductor substrate.

While the invention has been described mainly for a target in the form of a metal plate, the present invention is not limited thereto, and will also works for another electrically conductive targets capable of generating eddy currents, when moved in the vicinity of the proximity sensor device, for example a printed circuit board with one or more electrically conductive zones/areas/planes.

### REFERENCE NUMBERS:

- -00, -50: inductive proximity sensor system
- -01: inductive proximity sensor device
- -02: movable target
- -03: printed circuit board (PCB)
- -10: semiconductor substrate (e.g. ASIC)
- -13: transmitter circuit (or excitation circuit)
- -14: receiver circuit
- -15: evaluation circuit
- -16: switch
- -17: contact pad or contact area
- -18: current limiter
- -20: passive insert (e.g. glass substrate) with a plurality of through-vias
- -21: through-via
- -21t: top (surface) of through-via
- -21b: bottom (surface) of through-via
- -22: solder ball or solder bump
- -23: mould compound
- -24: (optional) filler
- -30: carrier wafer
- -31: removable or releasable tape
- TX1, TX2: first, second transmitter coil (or excitation coil)
- RX1, RX2: first, second receiver coil
- m1, m2, ...: metal layer 1, metal layer 2, ...
- d1, d2, ..: dielectric layer 1, dielectric layer 2, ...
- p1, p2, ...: passivation layer 1, passivation layer2, ...
- dz: distance in Z-direction
- dcs: distance between the coils and the solder balls or solder bumps
- L20,H20,W20: Length, height, Width of passive insert

## Claims

1. A proximity sensor device (101; 201; 301; 401; 501a, 501b), comprising:
- a first coil arrangement comprising a first excitation coil (TX1) and a first receiver coil (RX1) implemented in at least one first redistribution layer (RDL1, RDL2);
- a second coil arrangement comprising a second excitation coil (TX2) and a second receiver coil (RX2) implemented in at least one second redistribution layer (RDL3; RDL3, RDL4), spaced from the at least one first redistribution layer by at least 200 µm;
- a semiconductor substrate (10) arranged in a space between the at least one first redistribution layer (RDL1, RDL2) and the at least one second redistribution layer (RDL3; RDL3, RDL4) such that the at least one first redistribution layer (RDL1, RDL2) is arranged on a top side of the semiconductor substrate (10) and the at least one second redistribution layer (RDL3; RDL3, RDL4) is arranged on a bottom side of the semiconductor substrate (10);
and comprising an excitation circuit (213; 313) configured for exciting the first and second excitation coil (TX1, TX2),
and comprising a receiver circuit (214; 314) configured for receiving one or more signals from the receiver coils (RX1, RX2);
and comprising an evaluation circuit (215; 315) configured for determining a position or a value indicative of a position of an electrically conductive target (102; 202; 302); that is movable towards and away from the proximity sensor device, based on said one or more signals.

2. A proximity sensor device (101; 201; 301; 401) according to claim 1, implemented as a WLP fan-out package comprising or consisting of:
- a single semiconductor substrate (10);
- two or more first redistribution layers (RDL1, RDL2) arranged on a top side of the semiconductor substrate (10), and one or more second redistribution layers (RDL3, RDL4) arranged on a bottom side of the semiconductor substrate (10);
- a mould compound (23);
- a plurality of electrically conductive through-vias (21) provided in the mould compound and/or one or more mechanical insert (20 comprising a plurality of through-vias (21);
- a plurality of terminals;
- optionally a plurality of solder balls (22) or solder bumps provided on said terminals;
- optionally one or more filler blocks (24);
- optionally one or more discrete passive components selected from the group consisting of a diode, a resistor, a capacitor.

3. A proximity sensor device (101; 201; 301; 401) according to any of the previous claims,
wherein each of the first transmitter coil (TX1) and the first receiver coil (RX1) have a spiral shape implemented in one or more of said first redistribution layers (RDL1, RDL2) located above the semiconductor substrate (10);
and wherein each of the second transmitter coil (TX2) and the second receiver coil (RX2) have a spiral shape implemented in one or more of said second redistribution layers (RDL3; RDL3, RDL4) located under the semiconductor substrate (10).

4. A proximity sensor device (101; 201; 301; 401) according to any of the previous claims,
wherein an orthogonal projection of at least one of the transmitter coils (TX1, TX2) and the receiver coils (RX1, RX2) onto a virtual plane containing an active surface of the semiconductor substrate (10), is located at least partially outside the semiconductor substrate (10).

5. A proximity sensor device (101; 201; 301; 401) according to any of the previous claims,
wherein each of the first transmitter coil (TX1) and the first receiver coil (RX1) have a planar spiral shape implemented in a single redistribution layer (RDL2) located above the semiconductor substrate (10);
and wherein each of the second transmitter coil (TX2) and the second receiver coil (RX2) have a planar spiral shape implemented in a single redistribution layer (FIG. 5A: RDL3; FIG. 5B: RDL4) located under the semiconductor substrate (10).

6. A proximity sensor device (101; 201; 301; 401) according to any of the previous claims,
further comprising at least one passive substrate or passive insert (20) with a plurality of through-vias (21) extending from the first redistribution layer(s) to the second redistribution layer(s), for electrically connecting ends (t2a, t2b, r2a, r2b) of the second coil arrangement (TX2, RX2) to the excitation circuit (213) and/or to the receiver circuit (214).

7. A proximity sensor device (101; 201; 301; 401) according to any of the previous claims,
wherein the first transmitter coil (TX1) has a first spiral shape, and the first receiver coil (RX1) has a second spiral shape located inside the first spiral shape, and wherein the second transmitter coil (TX2) has a third spiral shape, and the second receiver coil (RX2) has a fourth spiral shape located inside the third spiral shape;
or wherein the first transmitter coil (TX1) has a first spiral shape, and the first receiver coil (RX1) has a second spiral shape located outside the first spiral shape, and wherein the second transmitter coil (TX2) has a third spiral shape, and the second receiver coil (RX2) has a fourth spiral shape located outside the third spiral shape.

8. A proximity sensor device (101; 201; 301; 401) according to any of the previous claims,
wherein the first transmitter coil (TX1) and the first receiver coil (RX1) are concentric, and wherein the second transmitter coil (TX2) and the second receiver coil (RX2) are concentric;
or wherein a largest distance between any two of four orthogonal projections of a geometric centre of the first transmitter coil (TX1), a geometric centre of the second transmitter coil (TX2), a geometric centre of the first receiver coil (RX1), a geometric centre of the second receiver coil (RX2) onto an imaginary plane containing the active surface of the semiconductor device (10), is smaller than 1.0 mm, or smaller than 0.75 mm, or smaller than 0.50 mm, or smaller than 0.25 mm.

9. A proximity sensor device (101; 201; 301; 401) according to any of the previous claims,
wherein the excitation circuit (213; 313) is configured for exciting the first transmitter coil (TX1) and the second transmitter coil (TX2) synchronously.

10. A proximity sensor device (101; 201; 301; 401) according to any of the previous claims,
wherein the transmitter coils (TX1, TX2) and the receiver coils (RX1, RX2) are configured such that a first voltage over the terminals (r1a, r1b) of the first receiver coil (RX1) and a second voltage over the terminals (r2a, r2b) of the second receiver coil (RX2) have a same amplitude within a predefined tolerance margin, in the absence of the conductive target (102; 202; 302).

11. A proximity sensor device (101; 201; 301; 401) according to any of the previous claims,
wherein the evaluation circuit (215; 315) is configured for determining a position of the movable target (102; 202; 302) relative to the proximity sensor device (101; 201; 301; 401), based on a sum of the induced voltages over the receiver coils (RX1, RX2), or based on a difference of the induced voltages over the receiver coils (RX1, RX2).

12. A proximity sensor device (201) according to any of the previous claims,
wherein the proximity sensor device (201) further comprises a switch (216) having two ends electrically connected to two terminals (P1, P2) of the proximity sensor device; and wherein the evaluation circuit (215) is further configured for determining a position of the target (202), and for selectively opening or closing the switch (216) depending on the position of the movable target (202).

13. A proximity sensor device (301) according to any of the previous claims,
wherein the evaluation circuit (315) is further configured for determining a position of the movable target (302), and for providing a signal to one of the terminals of the proximity sensor device (301) depending on the position of the movable target (302).

14. A proximity sensor system (100; 150) comprising:
- a proximity sensor device (101; 201; 301; 401) according to any of the previous claims;
- an electrically conductive target (102; 202; 302) being movable towards and away from the proximity sensor device.

15. Method (2100) of producing a proximity sensor device according to any of the claims 1 to 13, comprising the steps of:
a) providing (2101) a carrier wafer (30);
b) applying (2102) a removable or releasable tape (31), e.g. a thermal release tape or a laser release tape, on the carrier wafer (30);
c) placing (2103) one or more components (10, 20, 24) on the removable or releasable tape (31), the one or more components comprising at least a semiconductor substrate (10) and optionally one or more passive inserts (20) comprising a plurality of through-vias (21);
d) overmolding (2104) the wafer with a moulding compound (23) thereby forming a reconstituted wafer;
e) back-grinding (2105) the reconstituted wafer;
x) optionally making (2106) a plurality of openings in the moulding compound (23) extending to the removable or releasable tape, and filling them at least partially with a conductive material;
f) releasing (2107) the carrier wafer (30) and the removable or releasable tape tape (31) from the reconstituted wafer;
g) forming (2108) two or more first redistribution (RLD1, RDL2) layers on a first side of the reconstituted wafer, in electrical connection with contact areas (17) of the semiconductor substrate (10) and/or in electrical connection with top sides (21t) of said through-vias (21), and wherein these first RDL layers (RDL1, RDL2) comprise a first transmitter coil (TX1) and a first receiver coil (RX1);
h) forming (2109) one or more second redistribution layers (RLD3; RDL3, RDL4) on a second side of the reconstituted wafer, opposite the first side, in electrical connection with bottom sides (21b) of said through vias (21), wherein this one or more second RDL layer(s) comprise a second transmitter coil (TX2) and a second receiver coil (RX2);
i) optionally adding (2110) solder balls or solder bumps (22) on top of the one or more first or second redistribution layer(s);
j) singulating (2111) the reconstituted wafer.
